# EUROPEAN PATENT SPECIFICATION

(11) **EP 4 465 056 B1**
(45) Date of publication and mention of the grant of the patent: **09.09.2026**
(21) Application number: 23182241.2
(22) Date of filing: 29.06.2023
(51) Int. Cl.: G01R 31/08

(54) **DATA PROCESSING SYSTEM AND METHOD FOR DETERMINING A FAULT LOCATION, AND SYSTEM**
DATENVERARBEITUNGSSYSTEM UND VERFAHREN ZUR BESTIMMUNG EINER FEHLERSTELLE UND SYSTEM
SYSTÈME DE TRAITEMENT DE DONNÉES ET PROCÉDÉ DE DÉTERMINATION D'UN EMPLACEMENT DE DÉFAILLANCE, ET SYSTÈME

(30) Priority: 17.05.2023 IN 202341034494
(43) Date of publication of application: 20.11.2024
(60) Divisional application: 26194942.4
(73) Proprietor: Hitachi Energy Ltd, 8050 Zürich (CH)
(72) Inventor: Naidu, Obbalareddi Demudu, 560087 Bangalore (IN); Venkatesan, Aarthi, 600099 Chennai (IN)
(74) Representative: Meier, Florian

(56) References cited:
- CN-A- 106 841 919
- CN-A- 110 082 647
- CN-A- 112 034 305
- CN-A- 114 527 354
- US-A1- 2017 315 168

## Description

### TECHNICAL FIELD

Embodiments of the invention relate to data processing systems and methods operative to process measurements to determine a fault location. Embodiments of the invention relate in particular to data processing systems and methods which are operative to determine the fault location along a line of an electric power transmission system.

### BACKGROUND

Electric power systems are important infrastructure components. Electric power systems, such as power generation, transmission, and/or a distribution system, are complex systems. Faults can occur at various locations in such systems. Faults along a line (in particular a transmission line) may be of various types. Faults involving ground, such as phase-ground faults or phase-phase-ground faults, are the most common faults encountered in lines of electric power systems (in particular of electric power transmission grids).

Fault location determination techniques are important to establish a location of a fault along, e.g., a transmission line, which can have a length well in excess of 100 km.

The increasing integration of inverter-based renewable resources (IBRs) poses new challenges on fault location determination. First, renewable power plants are often positioned such that they have a significant spacing from load centers as they often require more land. Multiple interconnections are added to evacuate power from these power plants to load centers. Faults in transmission networks are not avoidable due to storms, lightning, snow, insulation breakdown, tree contact with a line and other external objects. Second, quick restoration of the faulted line is important to transfer the power generated by IBRs, otherwise, it can exacerbate imbalances in the grid. Third, during faults, the controlled phase angle of IBR current can result in a non-homogeneity in impedance calculation, as discussed in, e.g., N. George and O. D. Naidu, "Distance Protection Issues with Renewable Power Generators and Possible Solutions," 16th International Conference on Developments in Power System Protection (DPSP 2022), Mar.2022, pp. 1-6. This in turn causes large error in the apparent impedance calculation, especially for resistive faults.

Various localization techniques have been deployed, including traveling wave-based fault location techniques such as those disclosed in WO 2021/152157 A1. An impedance-based technique that can be implemented as a single-ended impedance-based fault locator is suggested by L. Eriksson et al., "An Accurate Fault Locator with Compensation For Apparent Reactance In The Fault Resistance Resulting From Remote-End Infeed," IEEE Transactions on Power Apparatus and Systems, vol. PAS-104, no. 2, pp. 423-436, Feb. 1985.

US 2017/0315168 A1 discloses systems and methods for calculating a location of faults that occur during pole-open conditions, including single-ended approaches and double-ended approaches. CN 110 082 647 A, CN 106 841 919 A, CN 112 034 305 A, and CN 114 527 354 A respectively disclose techniques related to fault locations.

Conventional impedance-based techniques, when implemented as single-ended techniques, attain an accuracy that is often in excess of 1% or 2%. This accuracy is good enough for short lines but may exacerbate the task of finding the fault (using, e.g., inspection teams and/or drones) for longer lines. IBRs, such as solar PV and full or partial converter wind farms, are integrated into the network fully or partially through power inverters/converters. With different control strategies adapted by grid codes, which are decided by regulators, IBR systems have different fault characteristics compared to traditional conventional sources. Grid codes and Fault Ride Through (FRT) requirements, changes the behavior of voltage and current signals of IBRs during fault. Conventional single-ended fault location principles are affected by the integration of IBRs. During faults, the controlled phase angle of IBR current results in non-homogeneity in impedance calculation, as mentioned above. This in turn causes large error in the apparent impedance calculation, especially for resistive faults. This results in the estimated fault location to be lesser or more than the actual fault location value.

A single-ended fault location method for grid-connected converter system based on control and protection coordination is presented in P. Chang et al., "A Single-Ended Fault Location Method for Grid-Connected Converter System Based on Control and Protection Coordination," in IEEE Transactions on Power Delivery, vol. 37, no. 4, pp. 3071-3081, Aug. 2022. A single-terminal fault location method for transmission lines integrated by the inverter-type source is proposed in P. Chang et al., "A Single-Terminal Fault Location Method for Transmission Lines Integrated by Inverter-Type Source," in IEEE Transactions on Power Delivery, vol. 37, no. 3, pp. 1704-1713, June 2022. These methods use converter control information in the fault location formulation. However, the required information about the specifics of the inverter control vary with grid codes and interconnection agreements. This information may, thus, not be readily available in field operation of a commercial real-world power grid.

The above-described challenges become more relevant with an expected further increase in renewable energy resources.

In view of the above, there is a need for enhanced systems and methods capable of determining a fault location.

### SUMMARY

It is an object of the invention to provide data processing systems and methods that provide enhanced techniques of locating a fault along a line for the most common types of faults (namely phase-ground faults and/or phase-phase-ground faults). It is an optional object of the invention to provide data processing systems and methods that facilitate fault location determination even in power grids that use environmentally friendly renewable energy resources, at least for phase-ground faults and/or phase-phase-ground faults. It is an optional object of the invention to provide data processing systems and methods operative to determine the fault location even when inverter-based resources are connected to one or both ends of the line via buses and/or even when no measurements obtained at a remote end of the line are available, at least for phase-ground faults and/or phase-phase-ground faults. It is an optional object of the invention to provide data processing systems and methods that can determine a fault location, at least for phase-ground faults and/or phase-phase-ground faults, when inverter-based resources (IBRs) are coupled to one or both ends of the line. It is a further optional object of the invention to provide data processing systems and methods operative to determine the fault location, at least for phase-ground faults and/or phase-phase-ground faults, both when used in association with a line that has an IBR coupled to one or both of its ends and when used in association with a line that has non-IBR power sources coupled to both of its ends.

According to the invention, a data processing system, a method, and a machine-readable instruction code as recited in the independent claims are provided. The dependent claims define preferred embodiments.

According to an aspect of the invention, there is provided a data processing system operative to determine a fault location along a line based on measurements performed at an end of the line. The data processing system comprises at least one interface operative to receive the measurements. The data processing system comprises at least one processing circuit operative to process the received measurements to determine a zero sequence fault current and perform a fault location determination based on the zero sequence fault current. The zero sequence fault current has a zero sequence fault current phase angle. The data processing system is operative such that the fault location determination is performed based on the zero sequence fault current phase angle.

Various effects and advantages are attained by the data processing system. The data processing system uses the zero sequence fault current phase angle for performing the fault location determination. This value can be inferred from measurements obtained at a single end of the line. Thus, the data processing system remains operative even when no measurements from the other end of the line are available. By using the data processing system. Thus, the data processing system is operative to use the zero-sequence current to estimate the non-homogeneity factor or the angle of deviation between the local and the fault current, addressing the need for reliable fault location determination that remains operable even when IBRs are coupled to one or both ends of the line. This, the data processing system affords a solution to the fault location determination problem that facilitates quick restoration of transmission lines in power grids coupled to environmentally friendly IBR resources. The data processing system remains operative to determine the fault location even when no IBRs are coupled to either end of the line.

The data processing system may be operative such that the fault location determination comprises a determination of a fault current phase angle based on the zero sequence fault current phase angle.

By virtue of this configuration, the data processing system is operative to determine the fault location using a fault location determination technique that requires the phase angle of the fault current (referred to as fault current phase angle herein). The fault current phase angle can be determined using current measurements obtained at one end of the line, allowing IBR-dependent effects in the faulted state to be taken into consideration using single-ended measurements.

The data processing system is operative such that the fault location determination comprises a determination of a line current phase angle in a faulted state based on the zero sequence fault current.

By virtue of this configuration, the data processing system is operative to determine the fault location using a fault location determination technique that requires the phase angle of the line current (referred to as line current phase angle herein). The line current phase angle can be determined using current measurements obtained at one end of the line and known line parameters (such as a zero sequence line impedance and a sequence-1 line impedance), allowing IBR-dependent effects in the faulted state to be taken into consideration using single-ended measurements.

The data processing system may be operative to determine the line current phase angle in the faulted state based on both a magnitude of the zero sequence fault current and based on the zero sequence fault current phase angle.

By virtue of this configuration, the line current phase angle can be determined using current measurements obtained at one end of the line and known line parameters (such as a zero sequence line impedance and a sequence-1 line impedance), allowing IBR-dependent effects in the faulted state to be taken into consideration using single-ended measurements.

The data processing system may be operative to determine the line current phase angle in the faulted state based on the zero sequence fault current and at least one current measurement for a faulted phase.

By virtue of this configuration, the line current phase angle can be determined using current measurements obtained at one end of the line and known line parameters (such as a zero sequence line impedance and a sequence-1 line impedance), allowing IBR-dependent effects in the faulted state to be taken into consideration using single-ended measurements.

The data processing system may be operative to determine the fault location for a phase-ground fault in which there is one faulted phase. The data processing system may be operative to determine the fault location for a phase-ground fault using a voltage measurement of the faulted phase during fault, a zero sequence current during the fault (which is based on current measurements for all, e.g., three phases), and a current measurement of the faulted phase during the fault, in combination with line parameters which are known and independent of the fault case (and which are typically stored in a storage system of the data processing system).

By virtue of this configuration, the data processing system is operative to determine the fault location using a single-ended technique, allowing IBR-dependent effects in the faulted state to be taken into consideration using the single-ended measurements.

The data processing system may be operative to determine the line current phase angle for a phase-ground fault as being equal to a phase angle of a sum of the zero sequence fault current multiplied by a multiplicative factor and a sequence-2-current of a current of the faulted phase.

By virtue of this configuration, the data processing system is operative to determine the line current phase angle for use in determining the fault location using a single-ended technique, allowing IBR-dependent effects in the faulted state to be taken into consideration using the single-ended measurements.

The multiplicative factor may be a function of line parameters of the line. The multiplicative factor may be a function of a zero sequence line impedance and a sequence-1 line impedance of the line.

By virtue of this configuration, the data processing system is operative to determine the multiplicative factor using line parameters stored in, e.g., a storage system of the data processing system, which are independent of the respective fault.

The data processing system may be operative to determine the line current phase angle for a phase-ground fault as being equal to a phase angle of three times the zero sequence fault current.

By virtue of this configuration, the data processing system is operative to determine the fault current phase angle for use in determining the fault location using a single-ended technique, allowing IBR-dependent effects in the faulted state to be taken into consideration using the single-ended measurements.

The data processing system may be operative to determine the fault location (measured as a fractional value relative to a length of the line from the end of the line at which the measurements are obtained) as being proportional to a sine of a difference of a phase angle of a voltage measured for the faulted phase in the fault minus the fault current phase angle. The data processing system may be operative to determine the fault location (measured as a fractional value relative to a length of the line from the end of the line at which the measurements are obtained) as being inversely proportional to a sine of a line impedance phase angle, and being further inversely proportional to a difference of
- a cosine of a difference of the fault current phase angle minus the line current phase angle minus
- a sine of the difference of the fault current phase angle minus the line current phase angle multiplied by a cotangent of a line impedance phase angle,
wherein the fault current phase angle is determined based on the zero sequence fault current, the line current phase angle is determined based on the phase angle of the sum of the zero sequence fault current multiplied by the multiplicative factor and a current measured for the faulted phase, and the line impedance angle being a line parameter stored in a storage system.

By virtue of this configuration, the data processing system is operative to determine the fault location using a single-ended technique, allowing IBR-dependent effects in the faulted state to be taken into consideration using the single-ended measurements.

The data processing system may be operative to determine the fault location (measured as a fractional value relative to a length of the line from the end of the line at which the measurements are obtained) as being dependent on the ratio of the two quantities discussed in the two paragraphs preceding this paragraph, multiplied by a magnitude of a voltage measured for the faulted phase divided by a product of all of the following: a magnitude of a sum of the current measured for the faulted phase and a product of the multiplicative factor and the zero sequence fault current, a line impedance of the line, and a sine of the line impedance phase angle.

By virtue of this configuration, the data processing system is operative to determine the fault location using a single-ended technique without using any inverter and/or source parameters of any IBRs coupled to one or both ends of the line, allowing IBR-dependent effects in the faulted state to be taken into consideration using the single-ended measurements and in a converter/source setting agnostic manner.

The data processing system may be operative to determine the fault location for a phase-phase-ground fault in which there is a first faulted phase and a second faulted phase. The data processing system may be operative to determine the fault location for a phase-phase-ground fault using a voltage measurement of the first faulted phase during fault, a voltage measurement of the second faulted phase during the fault, a zero sequence current during the fault (which is based on current measurements for all, e.g., three phases), a current measurement of the first faulted phase during the fault, and a current measurement of the second faulted phase during the fault, in combination with line parameters which are known and independent of the fault case (and which are typically stored in a storage system of the data processing system).

By virtue of this configuration, the data processing system is operative to determine the fault location using a single-ended technique, allowing IBR-dependent effects in the faulted state to be taken into consideration using the single-ended measurements.

The data processing system is operative to determine the line current phase angle for the phase-phase-ground fault as being equal to a phase angle of a sum of the zero sequence fault current multiplied by a multiplicative factor, a current measured for the first faulted phase, and a current measured for the second faulted phase.

By virtue of this configuration, the data processing system is operative to determine the line current phase angle for use in determining the fault location using a single-ended technique, allowing IBR-dependent effects in the faulted state to be taken into consideration using the single-ended measurements.

The multiplicative factor may be a function of line parameters of the line. The multiplicative factor may be a function of a zero sequence line impedance and a positive sequence line impedance of the line.

By virtue of this configuration, the data processing system is operative to determine the multiplicative factor using line parameters stored in, e.g., a storage system of the data processing system, which are independent of the respective fault.

The data processing system may be operative to determine the line current phase angle for a phase-phase-ground fault as being equal to a phase angle of three times the zero sequence fault current.

By virtue of this configuration, the data processing system is operative to determine the fault current phase angle for use in determining the fault location using a single-ended technique, allowing IBR-dependent effects in the faulted state to be taken into consideration using the single-ended measurements.

The data processing system may be operative to determine the fault location (measured as a fractional value relative to a length of the line from the end of the line at which the measurements are obtained) as being proportional to a sine of a difference of a phase angle of a sum of voltages measured for the first and second faulted phases in the fault state minus the fault current phase angle. The data processing system may be operative to determine the fault location (measured as a fractional value relative to a length of the line from the end of the line at which the measurements are obtained) as being inversely proportional to a sine of a line impedance phase angle, and being further inversely proportional to a difference of
- a cosine of a difference of the fault current phase angle minus the line current phase angle, minus
- a sine of the difference of the fault current phase angle minus the line current phase angle, the sine being multiplied by a cotangent of a line impedance phase angle,
wherein the fault current phase angle is determined based on the zero sequence fault current, the line current phase angle is determined based on the phase angle of the sum of the zero sequence fault current multiplied by the multiplicative factor, a current measured for the first faulted phase in the fault state, and a current measured for the second faulted phase in the fault state, and the line impedance angle is a line parameter stored in a storage system.

By virtue of this configuration, the data processing system is operative to determine the fault location using a single-ended technique, allowing IBR-dependent effects in the faulted state to be taken into consideration using the single-ended measurements.

The data processing system may be operative to determine the fault location (measured as a fractional value relative to a length of the line from the end of the line at which the measurements are obtained) as being dependent on the ratio of the two quantities discussed in the two paragraphs preceding this paragraph, multiplied by a magnitude of a sum of voltages measured for the first and second faulted phases in the fault state divided by a product of all of the following: a magnitude of a sum of the currents measured for the first and second faulted phases in the fault state plus 2 times the multiplicative factor times the zero sequence fault current in the fault state, a line impedance of the line, and a sine of the line impedance phase angle.

By virtue of this configuration, the data processing system is operative to determine the fault location using a single-ended technique without using any inverter and/or source parameters of any IBRs coupled to one or both ends of the line, allowing IBR-dependent effects in the faulted state to be taken into consideration using the single-ended measurements and in a converter/source setting agnostic manner.

The data processing system may be operative to determine a fault type and perform the fault location determination using processing operations that depend on the determined fault type.

By virtue of this configuration, the data processing system can be operative to determine the fault location both for phase-ground faults and for phase-phase-ground faults, using processing operations tailored for the respective fault type. Versatility of use of the data processing system is enhanced thereby.

The data processing system may be operative to perform different processing operations for determining the line current phase angle in the faulted state depending on whether the fault is a phase-ground fault or a phase-phase-ground fault.

By virtue of this configuration, the data processing system can be operative to determine the fault location both for phase-ground faults and for phase-phase-ground faults, using processing operations tailored for the respective fault type. Versatility of use of the data processing system is enhanced thereby.

The data processing system may be operative to perform identical processing operations for determining the fault current phase angle independently of whether the fault is a phase-ground fault or a phase-phase-ground fault.

By virtue of this configuration, the data processing system can determine the fault current phase angle for use in the fault location determination in a manner independent of the type of supported faults.

The data processing system may be operative to determine the zero sequence fault current phase angle independently of any measurements obtained at a remote end of the line.

By virtue of this configuration, the data processing system can determine the fault location using a single-ended technique.

The fault location determination is a single-ended fault location determination that uses the measurements obtained at a single end of the line and that is independent of any measurements obtained at a remote end of the line.

By virtue of this configuration, the data processing system can determine the fault location using a single-ended technique.

The data processing system may be operative to determine the zero sequence fault current phase angle independently of source parameters of one or several source(s) connected to the line via a bus.

By virtue of this configuration, the data processing system can determine the fault current phase angle for use in determining the fault location in a source-parameter agnostic manner, even when the source(s) comprise IBRs.

The data processing system may be operative to determine the zero sequence fault current phase angle independently of inverter settings of one or several inverters used to connect IBRs to the line via a bus.

By virtue of this configuration, the data processing system can determine the fault current phase angle for use in determining the fault location without requiring any knowledge of the inverter settings, even when used in association with a line having IBRs coupled thereto at one or both ends.

The data processing system may be operative to perform the fault location determination independently of source parameters of one or several source(s) connected to the line via a bus.

By virtue of this configuration, the data processing system can determine the fault location in a source-parameter agnostic manner, even when the source(s) comprise IBRs.

The data processing system may be operative to perform the fault location determination independently of inverter settings of one or several inverters used to connect IBRs to the line via a bus.

By virtue of this configuration, the data processing system can determine the fault location without requiring any knowledge of the inverter settings, even when used in association with a line having IBRs coupled thereto at one or both ends.

The fault location determination may be operative to determine the fault location for grounded faults.

By virtue of this configuration, the data processing system can determine the fault location for at least the most common types of faults in a single-ended and source-agnostic manner.

The data processing system may be operative to perform a fallback fault location routine if the fault is a non-grounded fault.

By virtue of this configuration, less common faults can also be dealt with. The fallback fault location routine may comprise a traveling wave technique or an impedance-based technique, without being limited thereto.

The data processing system may comprise a storage system having line parameters stored therein for use in the fault location determination. The line parameters may comprise a line impedance magnitude, a line impedance phase angle, a zero sequence line impedance, and a positive sequence line impedance.

By virtue of this configuration, parameters useful in determining the fault location in a source-agnostic and single-ended manner can be retrieved from the storage system.

The various phase angles may be defined relative to a reference time (for example as phase angle of a sine or cosine function at a given reference time). The data processing system may be operative to receive time information from a reference time source (such as a station or substation digital clock) at the interface and/or may comprise an internal reference time source (such as an internal digital clock).

By virtue of this configuration, the data processing system is operative to determine the phase angles for use in the fault location determination in a well-defined manner, using sources for timing information available to intelligent electronic devices (IEDs).

The various phase angles may be determined as argument of a complex-valued representation of the respective quantities. For illustration, the zero sequence fault current (which may be obtained by summing the currents for the different phases in the fault state) may be represented as a complex-valued number, with an argument of the complex-valued number being the zero sequence fault current phase angle.

By virtue of this configuration, the data processing system is operative to determine the phase angles for use in the fault location determination in an efficient manner, using well-established processing techniques.

The data processing system may be operative to generate output based on the determined fault location.

By virtue of this configuration, the result of the fault location determination is made available for further use, such as for use in a control operation. The control operation may comprise controlling a human machine interface (HMI) or execution of a control function.

The output may comprise an output via a human machine interface indicating the determined fault location. The data processing system may be operative to provide the output to facilitate, e.g., deployment of an engineering team, an inspection vehicle such as a drone or a robot.

By virtue of this configuration, re-establishment of the faulted transmission line is significantly aided.

The output may comprise a command or signals that triggers execution of at least one control function, in particular at least one protection function, based on the determined fault location.

By virtue of this configuration, the data processing system is operative to cause execution of a control function or of several control functions. The control function(s) may comprise function(s) that assist in the repair work and/or re-establishment of power after repair of the faulted line.

The line may be a power transmission line of a power transmission grid (such as a high voltage or extra high voltage lines).

By virtue of this configuration, the data processing system is operative for use in association with lines for which accurate determination of the fault location is particularly important.

The line may have several phases, in particular three phases.

The data processing system may comprise an intelligent electronic device (IED), comprising at least the interface and the at least one processing circuit. The IED may be an in-line IED.

By virtue of this configuration, the fault location can be implemented in a particularly convenient configuration.

The IED may be an IED operative in accordance with IEC 61850.

By virtue of this configuration, the IED can harness the benefits of transmission of measurements in accordance with IEC 61850 and/or of intra-substation communication in accordance with IEC 61850.

A station or substation of a power grid according to an embodiment comprises the data processing system according to an aspect or embodiment.

The effects attained by the station or substation correspond to the effects disclosed in association with the data processing system.

A system according to an embodiment comprises a line having a first end and a second end, and the data processing system of an aspect or embodiment. The data processing system is operative to determine a fault location along the line.

The effects attained by the system correspond to the effects disclosed in association with the data processing system.

The system may further comprise measurement instrumentation operative to measure currents and voltages at an end of the line. The interface may be operative to receive the measurements from the measurement instrumentation.

This configuration provides the effect of providing single-ended measurements to the data processing system for use in determining the fault location.

The system may further comprise one or several IBRs connected to the first end or the second end.

This configuration provides the effect of implementing a single-ended and source-agnostic fault location technique in a power grid connected to environmentally beneficial IBRs. Thus, the invention contributed to a transformation towards greener, environmentally friendly energy transmission systems.

According to another aspect of the invention, a method of determining a fault location along a line based on measurements performed at an end of the line. The method comprises processing, by at least one processing circuit, the measurements to determine a zero sequence fault current. The method further comprises performing, by the at least one processing circuit, a fault location determination based on the zero sequence fault current. The zero sequence fault current has a zero sequence fault current phase angle. The fault location determination is performed based on the zero sequence fault current phase angle. The fault location determination comprises a determination of a line current phase angle in a faulted state based on the zero sequence fault current. The at least one processing circuit determines the line current phase angle for a phase-phase-ground fault as being equal to a phase angle of a sum of the zero sequence fault current multiplied by a multiplicative factor, a current of a first faulted phase, and a current of a second faulted phase.

The effects attained by the method correspond to the effects disclosed in association with the data processing system and the system according to embodiments.

The method may be performed by, or using, the data processing system according to an aspect or embodiment.

Optional features of the method and the effects attained thereby correspond to the effects disclosed in association with the data processing system according to embodiments and the system according to embodiments.

According to another aspect of the invention, there is provided a use of the data processing system, the system, or the method according to any one aspect or embodiment for determining the fault location in an electric power transmission or distribution line in which there is an inhomogeneity, i.e., in which the fault current is not in phase with the line current of the faulted phase (phase-ground fault) or the sum of line currents of the faulted phase (phase-phase-ground fault).

According to another aspect of the invention, there is provided a use of the data processing system, the system, or the method according to any one aspect or embodiment for determining the fault location in an electric power transmission or distribution line having at least one IBR connected to one or both of its ends.

According to further embodiments, there is provided machine-readable instruction code which, when executed by at least one programmable circuit, causes the programmable circuit to perform the method according to an embodiment.

According to further embodiments, there is provided a non-transitory storage medium having stored thereon machine-readable instruction code which, when executed by at least one programmable circuit, causes the programmable circuit to perform the method according to an embodiment.

Various effects and advantages are attained by embodiments of the invention. For illustration, the data processing systems and methods according to embodiments provide enhanced techniques of determining a fault location along a line for grounded faults, which are applicable even when one or several IBRs are coupled to ends of the line. The data processing systems and methods are operative to determine the fault location for grounded faults without requiring information on inverter settings of inverters used to couple renewable energy resources to one or two buses at the ends of the line. The data processing systems and methods also provide enhanced accuracy compared to legacy single-ended techniques.

### BRIEF DESCRIPTION OF THE DRAWINGS

Embodiments of the invention will be described with reference to the drawings in which similar or identical reference signs designate elements with similar or identical configuration and/or function.
Figure 1 is a block diagram of a system comprising a data processing system.
Figure 2 is a block diagram of the data processing system.
Figure 3 is a flow chart of a data processing method.
Figure 4 is a circuit diagram showing a transmission line in a fault state for a phase-ground fault.
Figure 5 is a circuit diagram showing a transmission line in a fault state for a phase-phase-ground fault.
Figure 6 is a circuit diagram showing a transmission line in a fault state for a phase-phase-ground fault.
Figure 7 is a flow chart of a process that may be used in determining a fault location.
Figure 8 is a flow chart of a process that may be used in determining a fault location.
Figure 9 is a diagram of a system comprising the data processing system.
Figure 10 is a block diagram of the data processing system.
Figure 11 shows phase currents and voltages in a faulted state for a system having no inverter based resources and for a system having inverter based resources.
Figure 12 is a diagram of a system having an inverter based resource on one end of a line.
Figure 13 is a diagram of a system having an inverter based resources on both ends of a line.
Figure 14 is a block diagram of a data processing system.
Figure 15 is a flow chart of a method.

### DETAILED DESCRIPTION OF EMBODIMENTS

Embodiments of the invention will be described with reference to the drawings. In the drawings, similar or identical reference signs designate elements with similar or identical configuration and/or function.

While embodiments will be described in association with data processing systems that may be implemented in intelligent electronic devices (IEDs) and methods by such data processing systems, the embodiments are not limited thereto. Moreover, while embodiments will be described in association with exemplary inverter based resources (IBRs), such as photovoltaic (PV) or inverter-based wind energy resources, coupled to an end of a transmission line at a bus, the embodiments are not limited thereto.

The features of embodiments may be combined with each other unless specifically stated otherwise.

According to embodiments of the invention, a data processing system and method are provided which determine the fault location along a line, in particular a transmission line of a power transmission grid, for at least the grounded faults that are the most common faults in practice (phase-ground faults and phase-phase-ground faults). The data processing system and method are operative to use measurements obtained at one end of the line (also referred to as single-ended measurements) to determine one or several phase angles and/or non-homogeneity factors that are used in a fault location determination which uses the one or several phase angles and/or non-homogeneity factors as variables of an equation that specifies the fault location, in a manner that does not require information on inverter and/or source settings or parameters. The data processing system and method may be operative to determine the fault location using a processing that is non-iterative, thereby reducing the complexity of the task and facilitating its implementation in, e.g., an in-line IED, such as an in-line distance protection relay. The data processing system and method may be operative to determine the fault location in a single-ended technique for at least phase-ground and phase-phase-ground faults, using only measurements obtained at one end of the line (i.e., the near or local end). The need for communication between devices at the remote and near ends of the transmission line for the purpose of estimating the location of a phase-ground or phase-phase-ground fault is thereby obviated.

As used herein, the term "fault location" refers to information that indicates the location of a fault along the transmission line. The fault location can be a dimensionless number, specifying the location relative to the length of transmission line. For example, the fault location may be a number specifying the distance by which the fault is spaced from the near end of the transmission line (i.e., the end at which the measurements are obtained), divided by the length of the transmission line. Thus, the term "distance" or "location", when used as a dimensionless number herein, refers to a fraction of the line length as measured from the end of the transmission line at which the processed measurements are obtained.

As used herein, the term "determining a fault location" or "fault location determination" encompasses an approximate determination, in particular an estimation technique. This similarly applies to other uses of the term "determining" (such as in association with determining one or several phase angles), which also encompass an approximate determination, i.e., an estimation of the respective quantity.

As used herein, the term "phase angle" refers to a shift in one quantity relative to another. In a time domain, the phase angle can define the shift (also referred to as offset) of a sine or cosine-shaped curve relative. For complex-valued representations of quantities such as currents, voltages, and impedances (which are common and widely used in the art), the phase angle is the argument of the complex-valued number. The term "phase angle" is widely used in the art in this sense for complex-valued numbers and will be used in accordance with this conventional terminology herein.

The term "line", as used herein, encompasses in particular a transmission line of a power transmission system, such as an extra-high voltage or high voltage transmission line, without being limited thereto. The line can be a line with several phases, in particular three phases.

As used herein, the term IED refers to a device that may be operative in a manner compatible with or in accordance with IEC 61850, e.g., in accordance with the latest version of IEC 61850 as available on the filing date of this application (when filed as a priority application) or the priority date of this application (when filed as an application claiming the priority of an earlier application).

As used herein, a "voltage measurement" for a line may be a voltage measurement performed at an end of the line (which end is also referred to as the near or local end). The measurement may be obtained by a voltage transformer coupled to the line itself or to a bus at the end of the line. Thus, the term "voltage measurement at an end of the line" encompasses both a voltage measurement obtained using a voltage transformer coupled to the line close to one of its ends and a voltage measurement obtained using a voltage transformer coupled to the bus. The skilled person will appreciate that these two measurements do not significantly differ.

Current and voltage measurements used by the processing techniques and systems disclosed herein are generally obtained at a same end of the line. It will be appreciated that, in accordance with the skilled person's understanding, the term "end" encompasses an end region, such as a station or substation area of a station or substation at which the line connects to a bus.

The data processing system and method according to embodiments address the need for improved techniques of determining the fault location that are operable in cases in which IBRs are coupled to one or both ends of the transmission line, at least for phase-ground or phase-phase-ground faults. Embodiments provide data processing systems and methods for fault location for transmission networks connected to IBR systems. As will be described in more detail herein, the data processing system and method are operative to use a zero-sequence current (which is available from single-ended measurements) to estimate the non-homogeneity factor or the angle of deviation between a current in the line measured close to an end of the line (also referred to as line current) in the fault state and the fault current.

The data processing system and method according to aspects or embodiments may be operative to provide a fault location using single ended measurements without using source impedances and/or inverter settings.

The data processing system and method according to aspects or embodiments may be operative to determine a non-homogeneity angle (which may be affected by the presence of IBRs) based on local voltage and currents only. This obviates the need for using source impedances and/or inverter settings and for obtaining measurements from the remote end of the transmission line.

The data processing system and method according to aspects or embodiments may be operative such that a fault location error attributable to resistance and non-homogeneity is corrected using single-ended voltage and current measurements only.

The data processing system and method according to aspects or embodiments may be operative such that they provide the fault location both when used with homogeneous systems and when used with non-homogenous systems (such as systems having IBRs connected to one or both ends of the transmission line).

The data processing system and method according to aspects or embodiments may be operative to determine the fault location with an accuracy that is not significantly degraded by various inverter control types. The data processing system and method according to aspects or embodiments may be operative to determine the fault location with an accuracy that is not significantly degraded by whether IBRs are connected to one or both ends of the line.

Thus, the data processing system and method according to aspects or embodiments can provide various technical effects:
i. The data processing system and method does not require any information related to the IBR control strategy and/or parameters, which are generally proprietary and may not be available to the manufacturer of the data processing system. The data processing system and method is agnostic to the control structure, source impedance and parameters of the IBR.
ii. The data processing system and method does not require measurements other than local voltage and current measurements available at, e.g., a relay or IED terminal. No communication with a relay at the remote end of the line is required. This provides enhanced robustness to failures associated with communication latencies and/or loss of communication.
iii. The data processing system and method help in locating the fault accurately. Thus, they assist in reducing down-times in transmission systems or other power systems having IBRs connected to transmission lines.

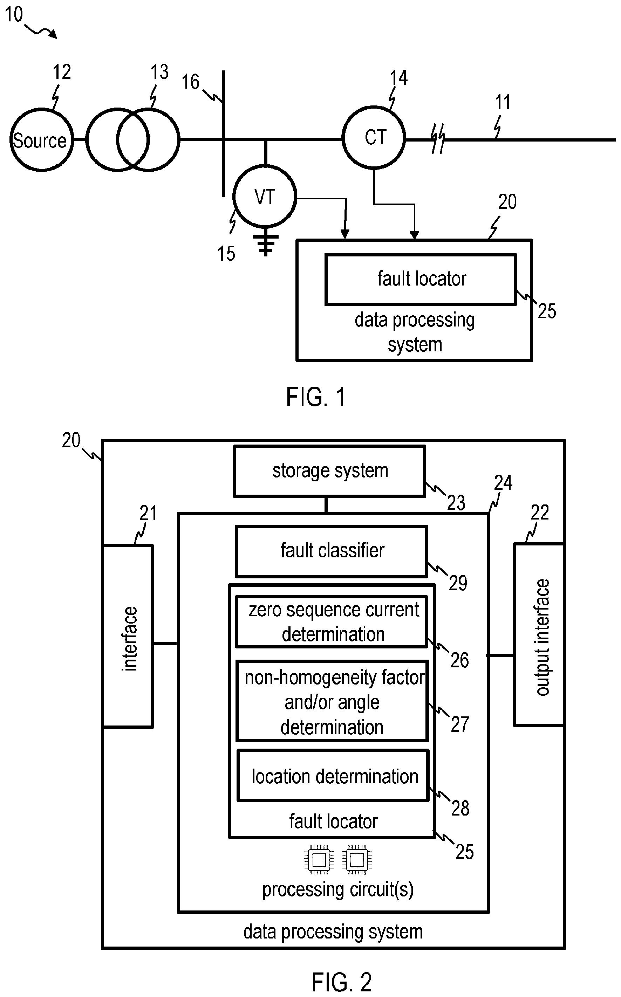

Figure 1 shows a system 10 comprising a data processing system 20 operative to determine a location of a fault along a transmission line 11. The system 10 may comprise a source 12 coupled to an end of the transmission line 11 at which measurements processed by the data processing system 10. This end is also referred to as near end or local end in the art. The source 12 may be coupled to the near end of the transmission line 11 at a bus 16 via a transformer or inverter 13. The source 12 may but does not need to comprise an IBR.

The data processing system 20 may be implemented as an apparatus comprising an apparatus housing in which some or all of the components illustrated in Figure 1 and Figure 2 are accommodated. The data processing system may be implemented as a combination of several apparatuses that are communicatively coupled to each other. The data processing system 20 may be operative to be used in combination with, and to co-operate with, control systems, control centers, protection and/or monitoring devices that use a result of a fault locator 25 of the data processing system 20.

The fault locator 25 may be operative to determine a fault location of a phase-ground fault or a phase-phase-ground fault using no measurements other than measurements obtained from one or several current transformers (CTs) 14 and one or several voltage transformers (VTs) 15 at the local end of the line 11. The fault locator 25 may be operative to additionally use line parameters of the line for determining the fault location. The fault locator 25 may be operative to determine the faut location using only the measurements obtained by the CTs 14 and the VTs 15 and the line parameters (with the latter being independent of the respective fault state and being accessible to the fault locator 25).

The fault locator 25 is operative to process the received measurements from the CTs 14 to determine a zero sequence fault current. The zero sequence fault current has a zero sequence fault current phase angle, which may be an argument (or phase angle) of a complex-valued number representing the zero sequence current. The fault locator 25 is operative such that the fault location determination is performed based on the zero sequence fault current phase angle. The fault locator 25 is operative such that a difference between a phase angle of a line current (referred to as line current phase angle herein) at the bus 16 in the fault state of the line 11 and a phase angle of a fault current (referred to as fault current phase angle) herein are determined based on the measurements from the CTs 14 and the voltage measurement(s) of the VT(s) 15, at least based on the voltage measurement(s) for the faulted phase of the phase-ground fault or phase-phase-ground fault.

Figure 2 is a block diagram of the data processing system 20. The data processing system 20 comprises at least one interface 21 to receive the measurements. The at least one interface 21 may be operative to receive the measurements as digital data (e.g., in a format conformant with IEC 61850) or analogue signals.

The data processing system 20 may comprise a storage system 23. The storage system 23 may be operative to store therein, or may have stored therein, line parameters of the line 11, which may be set during, e.g., configuration and/or commissioning of the data processing system 20. The line parameters may comprise a magnitude of the line impedance, a line impedance phase angle, a zero sequence line impedance and/or a positive sequence line impedance.

The data processing system 20 may comprise an output interface 22. The output interface 22 may comprise a human machine interface (HMI) and/or a data interface. The data processing system 20 may be operative to generate and provide, via the output interface 22 and/or the interface 21, output in dependence on the determined fault location. The data processing system 20 may be operative to provide output indicating the determined fault location to cause control of an HMI to indicate the determined fault location. The data processing system 20 may alternatively or additionally be operative to output fault location-dependent data or commands, which trigger execution of a control function based on the determined fault location (such as functions required to safeguard on-site personnel and/or functions required to re-establish the transmission line into operative mode).

The data processing system 20 comprises the fault locator 25. The data processing system 20 may optionally comprise a fault classifier 29 operative to determine the type of fault. In other implementations, the fault classifier 29 may be provided separately from the fault locator 25, with the fault locator 25 using a result of the fault classification 29 to determine which processing is to be invoked to determine the fault location, such as by determining which rules are to be used to estimate the line current phase angle in the fault state and/or the deviation of the line current phase angle in the fault state from the fault current phase angle. The fault classifier 29 is preferably a single-ended device requiring no measurements other than measurements obtained at the local end of the line. Various implementations of fault classifiers can be used. For illustration, impedance-based techniques and/or machine learning model-based techniques (such as those disclosed in WO 2021/099413 A1) and/or travelling wave techniques may be used to determine the type of fault. The skilled person is aware of various existing technologies for determining the type of fault.

The fault locator 25 is operative to determine the fault location along the line 11 for at least phase-ground faults and phase-phase-ground faults. The fault locator 25 may be triggered by detection of a fault of the phase-ground or phase-phase-ground type.

The fault locator 25 may be operative to perform a determination 26 of the zero sequence current. Determination of the zero sequence current may be implemented to include determination of a phase angle of the zero sequence current (referred to as zero sequence current phase angle herein), e.g., by determining the zero sequence current as a complex valued number and setting the zero sequence current phase angle equal to the argument of this complex valued number. Additional processing may be performed by the determination 26 module, such as determining the line current phase angle in the fault state from the measurements.

The fault locator 25 may be operative to perform a determination 27 of a non-homogeneity factor and/or various phase angles. This may comprise using the results of the determination module 26 for determining a deviation of the line current phase angle in the fault state from a fault current phase angle, based on the measurements.

The fault locator 25 may be operative to perform a fault location determination 28 for determining the fault location, based on, e.g., the processing of the measurements obtained at one end of the line 11 only, and further based on the line parameters in the storage system 23.

The fault locator 25 may be operative such that the specific processing operations for the determination 27 and/or the fault location determination 28 may be dependent on the specific type of fault, more specifically on whether the fault is a phase-ground fault or a phase-phase-ground fault and, in either case, on the faulted phase(s). The determination 27 and/or the fault location determination 28, and generally the processing performed by the fault locator 25 for any given fault, may use non-iterative processing, which lends itself to an implementation in, e.g., an in-line IED. For illustration, and as will be explained in more detail below, the operation of the fault locator 25 may be based on a set of closed-form solutions that dictate how to process the measurements into the fault location, without requiring an iterative technique.

To perform the various processing and, optionally, control operations, the data processing system 20 comprises at least one processing circuit 24. The at least one processing circuit 24 may be operative to perform the operation of at least the fault locator 25 and optionally of the fault classifier 29. The at least one processing circuit 24 may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

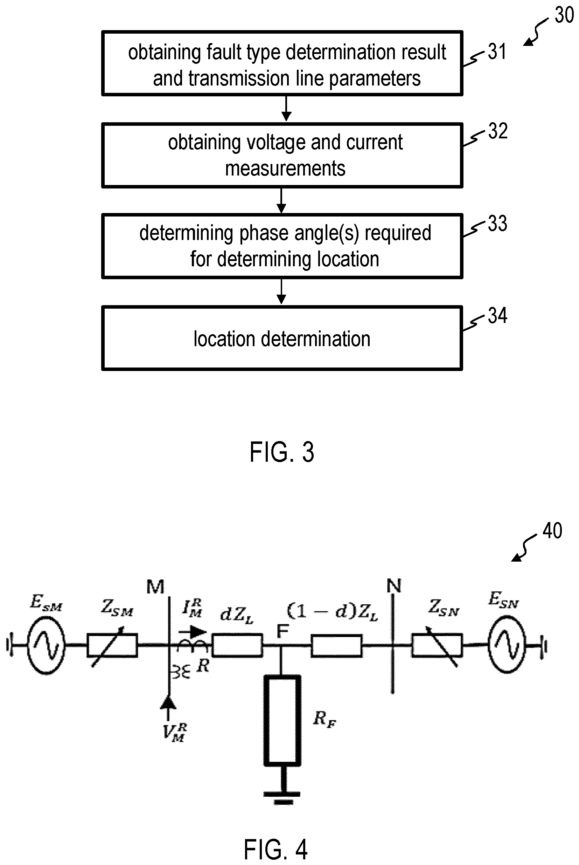

Figure 3 is a flow chart of a method 30 of processing data acquired or generated by a secondary system of a substation. The method 30 may be performed automatically by the processing circuit(s) 30 of the data processing device 20.

At process block 31, a fault type determination result is obtained. Obtaining the fault type determination may comprise a fault classification performed by the fault classifier 29. Also at process block 31, line parameters may be retrieved from, e.g., the storage system 23. The retrieved line parameters may comprise a magnitude of the line impedance, the line impedance phase angle, the zero sequence line impedance and the positive sequence line impedance.

At process block 32, voltage and current measurements are obtained. The obtained measurements may all be from a same end of the line..

At process block 33, one or several phase angles may be determined for use in determining the fault location. Process block 33 may comprise determining the zero sequence current in the fault state from current measurements. Process block 33 may comprise determining the fault current phase angle based on the zero sequence current. Process block 33 may comprise determining the line current phase angle in the faulted state based on the zero sequence current, and current measurement(s) for at least the faulted phases. Process block 33 may optionally also use a multiplicative factor that is dependent on at least some of the retrieved line parameters (such as the zero sequence line impedance and the positive sequence line impedance). Process block 33 may comprise determining the deviation of the line current phase angle in the faulted state from the fault current phase angle. Such a deviation may be caused by inverter settings which do not need to be known, but which inherently influence the deviation, which in turn affects the determined location of the fault.

At process block 33, the way in which the measurements are processed to obtain at least some of the mentioned phase angles (such as the line current phase angle in the faulted state) may be dependent on the type of fault, as indicated by the classification result obtained at process block 31.

At process block 34, the location determination is performed based on the phase angles determined at 33. Process block 34 may optionally also use additional measurements obtained at the local end, and line parameters. The location determination may be performed without using measurements from a remote relay (or other measurements at the remote end of the line), without using knowledge of inverter settings, and without using knowledge of source type and source parameters of any source(s) coupled to the near end of the line via the bus 16.

At process block 34, voltage measurements of at least the faulted phase(s) may also be used to determine the fault location. Both a phase angle of the voltage (such as the measured voltage(s) of the faulted phase(s) in the fault state) and its magnitude may be used to determine the fault location.

Figure 4 is a positive sequence diagram 40 for an A-g fault case (i.e., a phase-ground fault). The fault with phase-ground fault resistance R_{F} is at a distance d (measured as a fraction relative to the total line length) from a bus M. Measurements as used by the data processing system 20 are denoted by a superscript R. Generally, the data processing system can use the current and voltage measurements to determine (at least approximately) a phase angle of, inter alia, a line current I_{M}^{R} in the fault state, a phase angle and magnitude of a bus voltage V_{M}^{R} in the fault state, and a phase angle of the fault current.

These values may be used in any legacy technique that determines the fault location using any of these phase angles. In one specific example, which will be described in specific detail with reference to Equation (5) and Table 1 below as well as with further reference to Equation (7), a deviation of the fault current phase angle and the line current phase angle in the fault state may be determined from the single-ended measurements and combination with some of the line parameters (such as the zero sequence impedance and the positive sequence impedance of the line), to determine the fault location.

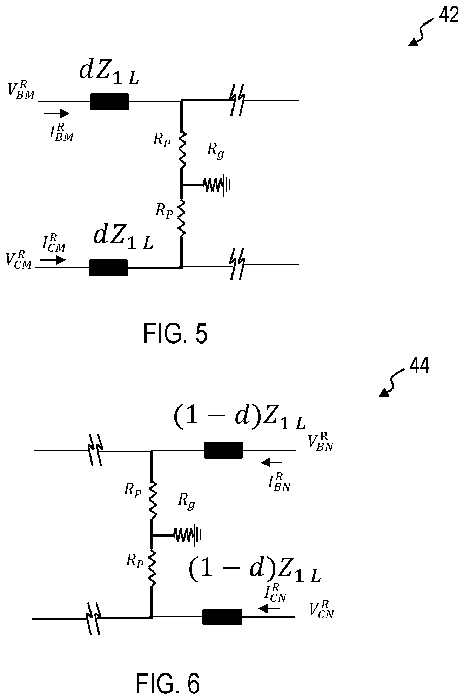

Figure 5 and Figure 6 are positive sequence diagrams 42, 44 for a phase-phase-ground fault case. The fault is at a distance d (measured as a fraction relative to the total line length) from a bus M and at a distance (1-d) from another bus N. Measurements as seen by the data processing system 20 are denoted by a superscript R. Generally, the data processing system 20 can use the current and voltage measurements to determine (at least approximately) a phase angle of, inter alia a line current I_{M}^{R} in the fault state, a phase angle and magnitude of a bus voltage V_{M}^{R} in the fault state, and a phase angle of the fault current.

The data processing system and method can localize the fault by using the measurements obtained in proximity to the bus M (as illustrated in Figure 5) or the measurements obtained in proximity to the bus N (as illustrated in Figure 6). It is not required that both sets of measurements be used. It is also not required for the data processing system 20 to know the types of source(s) (IBR(s) or non-IBR(s)), source parameters (such as source impedances), inverter or converter settings, or other system parameters other than the line impedance, line impedance angle, zero sequence line impedance and positive sequence line impedance, in order to determine the various phase angles and/or a non-homogeneity factor.

These values may be used in any legacy technique that determines the fault location using any of these phase angles and/or non-homogeneity factor for determining the location of a phase-phase-ground fault. In one specific example, which will be described in specific detail with reference to Equation (5) and Table 1 below as well as with further reference to Equation (7), a deviation of the fault current phase angle and the line current phase angle in the fault state may be determined from the single-ended measurements and combination with some of the line parameters (such as the zero sequence impedance and the positive sequence impedance of the line), to determine the fault location.

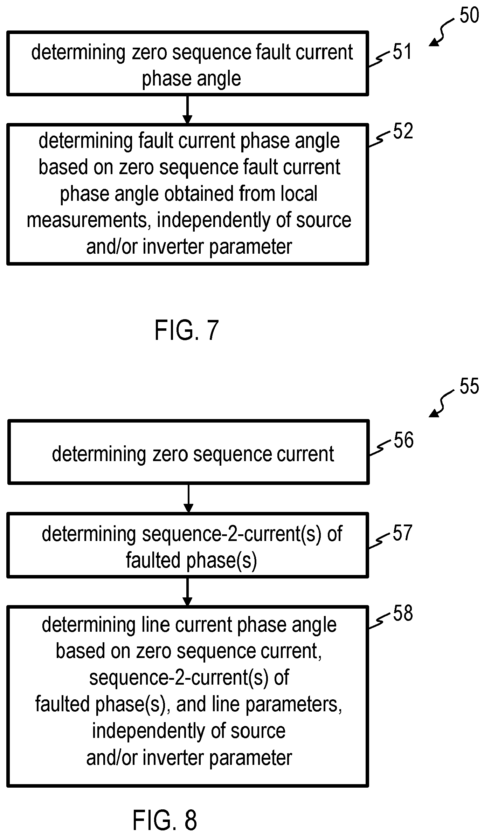

Figure 7 is a flow chart of a process 50. The process 50 may be performed automatically by the processing circuit(s) 24 to determine the fault location. The process 50 may be performed automatically by the processing circuit(s) 24 in process blocks 32 and 33 of the method 30.

At process block 51, the phase angle of the zero sequence current (which is also referred to as zero sequence current phase angle herein) is determined. Process block 51 may comprise determining the zero sequence current from the current measurements of the several phases of the line and determining the zero sequence current phase angle as argument of the zero sequence current.

At process block 52, the fault current phase angle is determined based on the zero sequence fault current phase angle obtained from local measurements, independently of source parameters, inverter settings, or converter settings of an inverter or converter interconnected between the source(s) and the bus(es).

Figure 8 is a flow chart of a process 55. The process 55 may be performed automatically by the processing circuit(s) 24 to determine the fault location. The process 55 may be performed automatically by the processing circuit(s) 24 in process blocks 32 and 33 of the method 30. The process 55 may be performed in combination with the process 50.

At process block 56, the zero sequence current is determined. Process block 51 may comprise determining the zero sequence current from the current measurements of the several phases of the line.

At process block 57, the current measurement(s) of the faulted phase(s) is/are processed. For illustration, current(s) for the faulted phase(s) in the fault state may be determined from the current measurements made in the fault state.

At process block 58, the line current phase angle in the fault state is determined based on the zero sequence current, the current(s) of the faulted phase(s) in the fault state, and a multiplicative factor that may be dependent on line parameters (such as zero sequence line impedance and positive sequence line impedance). The line current phase angle may be determined as an argument of a sum of the zero sequence current and a product of the current(s) of the faulted phase(s) in the fault state with a multiplicative factor that depends on the line parameters (such as zero sequence line impedance and positive sequence line impedance). The determination of the line current phase angle may be performed independently of source parameters, inverter settings, or converter settings of an inverter or converter interconnected between the source(s) and the bus(es).

The fault current phase angle (which may be obtained by the process of Figure 7) and the line current phase angle (which may be obtained by the process of Figure 8) may be used to determine a deviation (i.e. difference) of the line current phase angle in the fault state from the fault current phase angle. This deviation is affected by inhomogeneities that may be introduced by IBRs and can, thus, be taken into consideration without requiring knowledge of the inverter settings or source parameters.

Techniques that may be used for determining the fault location in a non-iterative and source-agnostic manner are described in detail below. It will be appreciated that the processing discussed above may also be used in other processing frameworks, such as techniques which use the fault current phase angle and line current phase angle in the fault state to determine the fault location and/or techniques that use a non-homogeneity factor to account for IBR-introduced inhomogeneities, if any.

Surprisingly, it has been found that the fault location can be determined in a single-ended and source-agnostic technique by determining (at least approximately) the following parameters:
The fault current phase angle *δ_{I_{F}}* can be determined based on the zero sequence current *I*_{0*_{F}*} in the fault state (and more particularly, based on the argument of the zero sequence current), e.g., in accordance with ${δ}_{{I}_{F}} = ∠ 3 {I}_{{0}_{F}} .$

In Equation (1), and generally herein, the symbol ∠ denotes the angle. This operator is also denoted as arg ( ) in the art. It will be appreciated that ∠3*I*₀*_{_{F}} =* ∠*I*_{0*_{F}*}, and that many other corresponding equations are possible. Thus, while the fault current phase angle *δ_{I_{F}}* is determined based on the zero sequence current in the fault state, this can be done in many ways.

The line current phase angle *δ_{I_{M}}* for a phase-ground fault related to a phase k (with k = A, B or C for a 3-phase transmission line) may be determined based on the current for the faulted phase (denoted as ${I}_{k}^{f}$), the zero sequence current *I_{0F},* and a multiplicative factor *k*₀ that is dependent on line parameters only, e.g., in accordance with: ${δ}_{{I}_{M}} = ∠ \left({I}_{k}^{f}+{k}_{0}{I}_{{0}_{F}}\right) .$

The multiplicative factor *k*₀ is dependent on line parameters only (which are known and set in the data processing system 20) and is independent on source parameters, converter settings or inverter settings. The multiplicative factor may be determined in accordance with, e.g., ${k}_{0} = \frac{{Z}_{{0}_{L}} - {Z}_{{1}_{L}}}{{Z}_{{1}_{L}}} .$

In Equation (3), and throughout this application, *Z*_{0*_{L}*} denotes the zero sequence line impedance, and *Z*_{1*_{L}*} denotes the positive sequence line impedance.

The line current phase angle *δ_{I_{M}}* for a phase-phase-ground fault with faulted phases k, l (with *k, l* = *A, B* or *C* for a 3-phase transmission line) is determined based on the currents for the faulted phases (denoted as ${I}_{k}^{f}$ and ${I}_{l}^{f}$), the zero sequence current *I*₀*_{F},* and the multiplicative factor *k*₀ that is dependent on line parameters only, e.g., in accordance with: ${δ}_{{I}_{M}} = ∠ \left({I}_{k}^{f}+{I}_{l}^{f}+2{k}_{0}{I}_{{0}_{F}}\right) .$

In Equation (4), the multiplicative factor *k*₀ may be determined based on line parameters only, in accordance with Equation (3).

Surprisingly, it has been found that the fault location d (as a fraction of the total line length) can be determined, using the results of the above-determined phase angles, in accordance with, e.g., $d = \frac{\frac{\left|{V}_{M}^{R}\right|}{\left|{I}_{M}^{R}\right|} sin \left({δ}_{{V}_{M}}-{δ}_{{I}_{F}}\right)}{\left(\left|{Z}_{L}\right|sin\left({θ}_{L}\right)\right) \left[\left.cos\left({δ}_{{I}_{F}}-{δ}_{{I}_{M}}\right)-cot\left({θ}_{L}\right)sin\left({δ}_{{I}_{F}}-{δ}_{{I}_{M}}\right)\right)\right]} .$

In Equation (5), ${V}_{M}^{R}$ is dependent on the voltage measurement(s) for the faulted phase(s). For illustration, ${V}_{M}^{R}$ may be a voltage for the faulted phase (phase-ground fault) in the fault state or a sum of voltages for the faulted phases (phase-phase-ground fault) in the fault state. In Equation (5), *δ_{V_{M}}* is a phase angle of the voltage for the faulted phase (phase-ground fault) in the fault state or of a sum of voltages (phase-phase-ground fault) in the fault state. In Equation (5), ${I}_{M}^{R}$ is dependent on the multiplicative factor *k*₀ of Equation (3), the zero sequence current, and the current(s) for the faulted phase(s). *Z_{L}* denotes the line impedance. *θ_{L}* denotes the phase angle of the line impedance (also referred to as line impedance phase angle herein).

The determination of the various measurements that are processed using the above-described equations is summarized in Table 1 below, where *I_{F}* denotes the fault current (which is the argument of the function on the right-hand side of Equation (1)):

**Table 1**

| Fault Type | ${V}_{M}^{R}$ | ${I}_{M}^{R}$ | *I_{F}* |
|---|---|---|---|
| A-g | *V_{A}* | *I_{_{A}} + k*_{₀}*I*_{_{0F}} | 3*I*_{_{0*F*}} |
| B-g | *V_{B}* | *I_{_{B}} + k*_{₀}*I*_{_{0*F*}} | 3*I*_{_{0*F*}} |
| C-g | *V_{C}* | *I_{_{C}}* + *k*_{₀}*I*_{_{0*F*}} | 3*I*_{_{0*F*}} |
| ABg | *V_{A} + V_{B}* | *I_{_{A}} + I_{_{B}}* + 2*k*_{₀}*I*_{_{0*F*}} | 3*I*_{_{0*F*}} |
| BCg | *V_{B} + V_{C}* | *I_{_{B}} + I_{_{C}} +* 2*k*_{₀}*I*_{_{0*F*}} | 3*I*_{_{0*F*}} |
| CAg | *V_{C}* + *V_{A}* | *I_{_{C}}* + *I_{_{A}}* + 2*k*_{₀}*I*_{_{0*F*}} | 3*I*_{_{0*F*}} |

Various modifications of the above processing may be performed. For illustration, rather than using Equation (1), the fault current phase angle may be determined in accordance with ${δ}_{{I}_{F}} = ∠ {I}_{{0}_{F}} .$

Similarly, various modifications may be made to the way in which the multiplicative factor *k*₀, if used, is determined. For illustration, it is possible to scale the multiplicative factor as compared to Equation (3), with a corresponding scaling of the zero sequence fault current definition ensuring that the product of the multiplicative factor and the zero sequence fault current remains the same.

The results of the fault location determination may be used in various ways, such as by initiating repair and/or performing operation functions.

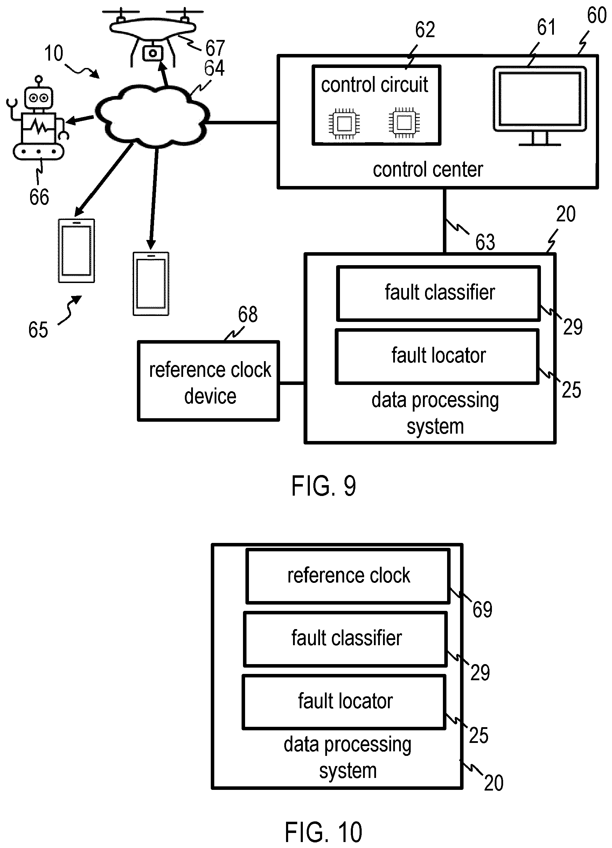

Figure 9 is a diagram of a system 10 comprising the data processing system 20 operative to determine the fault location for phase-ground faults and phase-phase-ground faults. The data processing system 20 may be operative to provide the results of the fault location determination to a control center 60 or other control system, for outputting by an HMI 61 or for use by a control circuit 62. The control circuit 62 and its functions may also be implemented in the data processing system 20 (in which case the control center 60 may be omitted).

The data processing system 20 and/or the control center may cause the fault location to be displayed at terminal devices 65 (such as terminal devices of field personnel), or by further inspection systems such as an inspection robot 66 or inspection drone 67.

When the system 10 comprises the control center 60, the data processing system 20 may provide the fault location to the control center 60 via a dedicated communication connection 63 or via a communication network (such as an inter-substation communication infrastructure). Data or commands dependent on the fault location may be provided to the terminal devices 65 or other controllable devices via wide area network 64 and/or a cellular communication network.

Phase angles determined from time-dependent measurements may be determined with reference to a reference time signal. The reference time signal may be provided by a reference clock 68 which may be implemented in a device 68 separate from the data processing system, such as a station or substation level reference clock device.

Figure 10 shows an alternative implementation in which an internal reference clock 69 may be used to determine phase angles of various measured quantities relative to a consistent time basis, which is provided by the reference clock 69.

Examples demonstrating the good performance of the data processing system 20 and method according to embodiments are provided below. These examples are illustrative and non-exhaustive. A technical advantage of the data processing system 20 and method according to embodiments over a legacy, state of the art source-agnostic, single-ended, and non-iterative fault locator is that the data processing system 20 and method according to embodiments perform well both for power systems having IBRs connected to one or both ends of the line and for power systems having conventional power sources only. The IBRs introduce non-homogeneities, as discussed above, which pose a challenge for single-ended non-iterative legacy techniques.

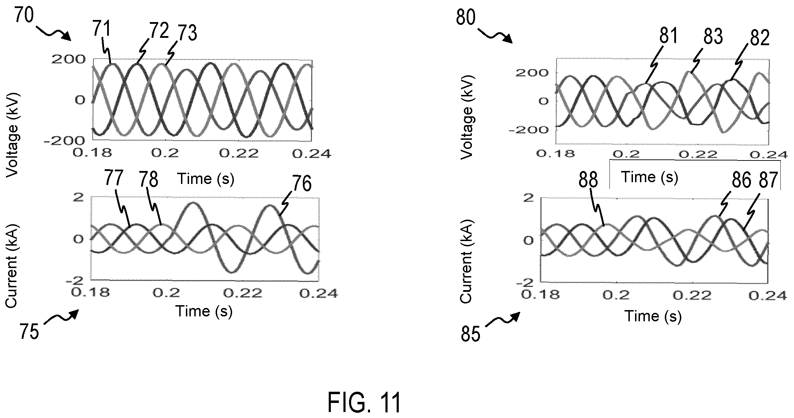

Figure 11 illustrates the effect of the non-homogeneities. Figure 11 shows currents 70 for phase A (71), phase B (72), and phase C (73) and voltages 75 for phase A (76), phase B (77), and phase C (78), respectively as a function of time, for a system having no IBRs. As evidenced by Figure 11, the magnitudes are affected by a fault (at approximately time 0.2 s), but there are no significant non-homogeneities.

Figure 11 also shows currents 80 for phase A (81), phase B (82), and phase C (83) and voltages 85 for phase A (86), phase B (87), and phase C (88), respectively as a function of time, for a system having an IBR connected to one of the buses at the ends of the line (but not the other one). As evidenced by Figure 11, there are significant non-homogeneities after the fault (at approximately time 0.2 s). The non- homogeneities are even more pronounced when IBRs are connected to the buses on both ends of the line.

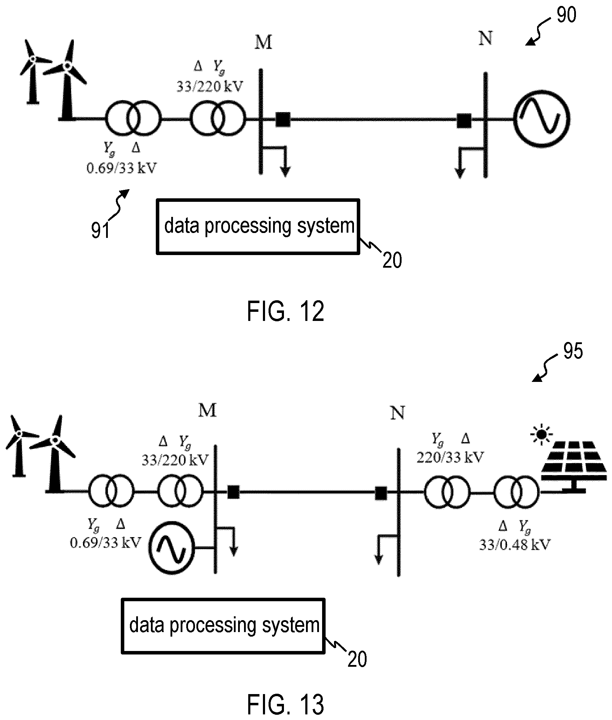

Figure 12 illustrates a system 90 comprising a transmission line having an IBR connected to one end of the line (at bus M). The data processing system 20 is operative to determine the fault location for this case, without requiring knowledge of the source configuration, source parameters, inverter settings, or inverter control strategies.

Figure 13 illustrates a system 95 comprising a transmission line having IBRs connected to both ends of the line (at bus M and at bus N). The data processing system 20 is operative to determine the fault location for this case, without requiring knowledge of the source configuration, source parameters, inverter settings, or inverter control strategies.

The following examples include test cases having IBRs connected to at least one end of the line. *First performance comparison example*

This scenario relates to a system in which there is an IBR at one end of the line only, as shown in Figure 12. This configuration is common for today's situation of renewable power plant integration. A 220kV, 150km long transmisison line is used for performance verification. For further breadth of comparison, a system having non-IBR sources on both ends of the line is also considered in the performance comparison. Two situations are considered:
***Case**- A-g Fault at 50% of the Line with R_{F}*=*10Ω:* Consider a fault at 50% of the line length from Bus M of the line with and without IBR for scenario 1 as shown in Figure 12. In the comparison, the IBR is modelled using North American grid code. The voltage and current signal measured at Bus M are shown in Figure 11 (right-hand side) for the IBR. The current magnitude is limited and modulated for IBR connected cases as shown in the right-hand side of Figure 11.

The calculated fault location using the conventional single-ended fault locator is 76.14 km for lines connected with conventional sources (grid) at both ends. The absolute percentage of fault location error is 0.76% for a 150 km line. The estimated fault location for the case when IBR is connected at Bus M is null (Not applicable) as the fault location obtained is more than the fine length for the conventional single-ended fault locator. In this case, the conventional method does not provide any fault location for the IBR scenario. The fault location error is increased for lines with IBR(s) when using the conventional fault locator. The data processing system and method according to embodiments (using a fault location determination as described above in association with Equations (1) to (5)) in both situations (i.e., lines connected with conventional sources and IBR connected system) provide fault locations of 75.95 and 76.19 km respectively. The absolute error obtained is ~0.79% for both cases. The performance comparison result is summarized in the Table 2:

**Table 2: Performance comparison result**

| Test Case | Conventional single ended fault locator | | | Embodiment | | |
|---|---|---|---|---|---|---|
| | FL (km) | Error (km) | Error (%) | FL (km) | Error (km) | Error (%) |
| Non-IBR sources at both ends: | 76.14 | 1.14 | 0.76 | 75.946 | 0.946 | 0.63 |
| A-g fault at 50% (75km), R_{F} 10Ω | | | | | | |
| One end IBR, remote end non-IBR: | NA | NA | NA | 76.19 | 1.19 | 0.79 |
| A-g fault at 50% (75km), R_{F} 10Ω | | | | | | |

### Second performance comparison example

This example corresponds to the first performance comparison example, but with the fault being at 36% (54km) from bus M. In the example with IBR, IBRs were present on both ends of the line (Figure 13).

The results are summarized in Table 3 below:

**Table 3: Performance comparison result**

| Test Case | Conventional single ended fault locator | | | Embodiment | | |
|---|---|---|---|---|---|---|
| | FL (km) | Error (km) | Error (%) | FL (km) | Error (km) | Error (%) |
| Non-IBR sources at both ends: | 55.09 | 1.09 | 0.73 | 54.85 | 0.85 | 0.56 |
| A-g fault at 36% (54km), R_{F} 10Ω | | | | | | |
| Both ends IBR | NA | NA | NA | 55.31 | 2.32 | 0.87 |
| A-g fault at 36% (54km), R_{F} 10Ω | | | | | | |

### Third performance comparison example

Performance was tested for various additional fault types and fault locations for a system having an IBR on one end of the line and a non-IBR source on the other end of the line. The results are shown in Table 4 below:

**Table 4: Performance comparison result**

| | Test Case | Conventional single ended fault locator | | | | | | | Embodiment | | | | |
|---|---|---|---|---|---|---|---|---|---|---|---|---|---|
| | | | FL | | Error | | Error | | FL | | Error | | Error |
| | | (km) | | (km) | | (%) | | (km) | | (km) | | (%) | |
| Ag fault at 10% (15km), R_{F} 0.01Ω | | | 113.59 | | 98.53 | | **65.69** | | 15.54 | | 0.54 | | **0.36** |
| Ag fault at 50% (75km), R_{F} 0.01Ω | | | NA | | NA | | **NA** | | 75.14 | | 0.14 | | **0.09** |
| Ag fault at 84% (126km), R_{F} 0.01Ω | | | NA | | NA | | **NA** | | 126.92 | | 0.92 | | **0.61** |
| Ag fault at 10% (15km), R_{F} 10Ω | | | 114.03 | | 99.03 | | **66.023** | | 15.70 | | 0.70 | | **0.46** |
| Ag fault at 50% (75km), R_{F} 10Ω | | | NA | | NA | | **NA** | | 76.19 | | 1.19 | | **0.79** |
| Ag fault at 84% (126km), R_{F} 10Ω | | | NA | | NA | | **NA** | | 129.16 | | 3.16 | | **2.11** |
| BCg fault at 24% (36km), R_{F} 0.01Ω | | | 32.29 | | 3.701 | | **2.46** | | 36.03 | | 0.03 | | **0.02** |
| BCg fault at 64% (96km), R_{F} 0.01Ω | | | 90.82 | | 5.17 | | **3.45** | | 97.03 | | 1.03 | | **0.68** |
| BCg fault at 90% (135km), R_{F} 0.01Ω | | | 130.59 | | 4.40 | | **2.93** | | 135.01 | | 0.01 | | **0.01** |
| BCg fault at 24% (36km), R_{F} 10Ω | | | NA | | NA | | **NA** | | 36.57 | | 0.57 | | **0.38** |
| BCg fault at 64% (96km), R_{F} 10Ω | | | NA | | NA | | **NA** | | 96.18 | | 0.18 | | **0.12** |
| BCg fault at 90% (135km), R_{F} 10Ω | | | NA | | NA | | **NA** | | 138.37 | | 3.37 | | **2.22** |

### Fourth performance comparison example

Performance was tested for various additional fault types and fault locations for a system having IBRs on both ends of the line. The results are shown in Table 5 below:

**Table 5: Performance comparison result**

| Test Case | Single ended fault locator | | | Proposed method | | |
|---|---|---|---|---|---|---|
| | FL (km) | Error (km) | Error (%) | FL (km) | Error (km) | Error (%) |
| Ag fault at 5% (7.5km), R_{F} 0.01Ω | 8.004 | 0.504 | **0.336** | 7.711 | 0.211 | **0.141** |
| Ag fault at 36% (54km), R_{F} 0.01Ω | 52.667 | 1.333 | **0.888** | 55.601 | 1.601 | **1.067** |
| Ag fault at 50% (75km), R_{F} 0.01Ω | 69.709 | 5.291 | **3.527** | 75.545 | 0.545 | **0.363** |
| Ag fault at 5% (7.5km), R_{F} 10Ω | NA | NA | **NA** | 9.993 | 2.493 | **1.662** |
| Ag fault at 36% (54km), R_{F} 10Ω | 23.092 | 30.908 | **20.606** | 57.030 | 3.030 | **2.020** |
| Ag fault at 50% (75km), R_{F} 10Ω | NA | NA | **NA** | 76.196 | 1.196 | **0.798** |
| BCg fault at 5% (7.5km), R_{F} 0.01Ω | 6.290 | 1.210 | **0.807** | 7.364 | 0.136 | **0.091** |
| BCg fault at 36% (54km), R_{F} 0.01Ω | 73.304 | 19.304 | **12.869** | 55.930 | 1.930 | **1.287** |
| BCg fault at 50% (75km), R_{F} 0.01Ω | 71.142 | 3.858 | **2.572** | 78.849 | 3.849 | **2.566** |
| BCg fault at 5% (7.5km), R_{F} 10Ω | NA | NA | **NA** | 8.547 | 1.047 | **0.698** |
| BCg fault at 36% (54km), R_{F} 10Ω | NA | NA | **NA** | 59.480 | 5.480 | **3.653** |
| BCg fault at 50% (75km), R_{F} 10Ω | NA | NA | **NA** | 79.593 | 4.593 | **3.062** |

### Conclusion on performance comparison example

The data processing system 20 and method according to embodiments determines the fault location more reliably in cases in which there is an IBR at at least one end of the line. Thus, the data processing system 20 and method have wide applicability and offer advantages as compared to conventional single-ended, source agnostic, non-iterative techniques.

The data processing system 20 may be implemented in various ways, such as a dedicated apparatus, or an in-line protection device.

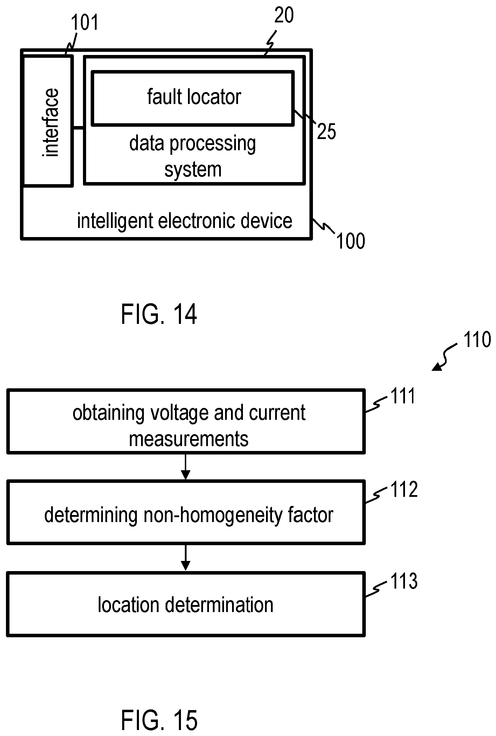

Figure 14 shows an implementation of an embodiment, in which an intelligent electronic device 100 (which may be an in-line relay) comprises the data processing system 20 according to any aspect or embodiment disclosed herein.

While embodiments have been described in which phase angles are determined based on single-ended measurements for use in a processing that requires, e.g., the deviation of the fault current phase angle and the line current phase angle in the faulted state to determine the fault location, the techniques disclosed herein are also applicable to a wide variety of other techniques. For illustration, there exist fault location techniques that use a non-homogeneity factor in determining the fault location. The techniques disclosed herein are also applicable to such scenarios.

Figure 15 is a flow chart of a method 110. The method 110 may be performed automatically by the data processing system 20.

At process block 111, voltage and current measurements are obtained from one end of the line, but not from the other (remote) end.

At process block 112, a non-homogeneity factor is determined based on the measurements obtained at the near end. Determining the non-homogeneity factor may comprise determining a deviation of a phase angle of a fault current from a line current of the faulted phase(s), using measurements obtained at a single end of the line only and without using parameters of sources (such as source settings, source impedances, and inverter settings) connected to buses at ends of the line.

At process block 113, the non-homogeneity factor is used for performing the location determination to determine the fault location.

It will be appreciated that, while embodiments have been described above, modifications may be implemented. The equations provided above for illustrating operation of an embodiment may be modified in various ways, while still using the concept of determining effects caused by a non-homogeneity of the system (which may be reflected by a deviation of fault current phase angle from line current phase angle of the faulted phase(s) in the fault state) by a technique that is
- a single-ended technique that requires measurements obtained at a single end of the line only, and
- a source-agnostic technique that does not require any information on the type of source (IBR-based or not), the source settings and parameters, and settings of an inverter by which the source may be connected to a bus at an end of the line.

For further specific illustration, existing single-ended fault location techniques (such as those discussed in L. Eriksson et al., "An Accurate Fault Locator with Compensation For Apparent Reactance In The Fault Resistance Resulting From Remote-End Infeed," IEEE Transactions on Power Apparatus and Systems, vol. PAS-104, no. 2, pp. 423-436, Feb. 1985) can be based on a solution of $J \left(\frac{{V}_{M}^{R}}{{I}_{M}^{R}}\right) = J \left(d {Z}_{L}\right) + J \left(\left|\frac{{I}_{F}}{{I}_{M}^{R}}\right|{R}_{F}{e}^{i \left({δ}_{{I}_{F}}-{δ}_{{I}_{M}}\right)}\right)$ for *d*, where *d* denotes the fault location (measured as a fraction of line length from the local or near end), 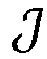 ( ) denotes an operator that provides the imaginary part of its argument, ${V}_{M}^{R}$ is a voltage obtained from voltage measurements for the faulted phase, ${I}_{M}^{R}$ is a current obtained from current measurements for at least the faulted phase, and *I_{F}* is the fault current. *Z_{L}* denotes the line impedance. *R_{F}* denotes the fault resistance. *δ_{I_{F}}* denotes the fault current phase angle. *δ_{I_{M}}* denotes the phase angle for the line current in the faulted phase. Equation (7) is provided for the example of a phase-ground fault.

Conventional single-ended fault locator techniques operate based on the assumption that there are no IBRs. Under this assumption, the homogeneity assumption applies, i.e., *δ_{I_{F}} - δ_{I_{M}}* ≈ 0. Based on this assumption, the second term on the right-hand side of Equation (7) is zero.

The presence of IBRs can introduce inhomogeneities, such that a finite value *δ_{I_{F}} - δ_{I_{M}}* is to be taken into account for accurate fault location determination. Techniques such as those disclosed in P. Chang et al., "A Single-Terminal Fault Location Method for Transmission Lines Integrated by Inverter-Type Source," in IEEE Transactions on Power Delivery, vol. 37, no. 3, pp. 1704-1713, June 2022 estimate the non-homogeneity (e.g., by estimating the value *δ_{I_{F}} - δ_{I_{M}}*) based on source parameters. A drawback of such approaches is that source parameters and settings tend to vary for IBRs, e.g. due to changing inverter settings.

According to the present invention, the various quantities required for determining the fault location in accordance with Equation (7) (or in accordance with Equation (5)) can be determined in a source-agnostic manner. In particular, the inhomogeneity factor that causes *δ_{I_{F}} - δ_{I_{M}}* to be non-zero can be determined by determining the fault current phase angle based on the zero sequence fault current (e.g., as *δ_{I_{F}} =* ∠3*I*_{0*_{F}*} or as *δ_{I_{F}} =* ∠*I*_{0*_{F}*}). The phase angle of the current in the faulted phase(s) can be determined using, e.g., Equations (2) and (4). It will be appreciated that no source parameters are required in these determinations.

For further illustration, the techniques disclosed herein for determining the fault current phase angle and/or the phase angle of the current for the faulted phase(s) can be applied to a wide variety of existing fault location techniques, such as those of
- L. Eriksson et al., "An Accurate Fault Locator with Compensation For Apparent Reactance In The Fault Resistance Resulting From Remote-End Infeed," IEEE Transactions on Power Apparatus and Systems, vol. PAS-104, no. 2, pp. 423-436, Feb. 1985), where the techniques disclosed herein are useful to determine the fault location without having to make the homogeneity assumption (i.e., the techniques disclosed herein can be used to determine the quantities that are set to zero under the homogeneity assumption), or
- P. Chang et al., "A Single-Terminal Fault Location Method for Transmission Lines Integrated by Inverter-Type Source," in IEEE Transactions on Power Delivery, vol. 37, no. 3, pp. 1704-1713, June 2022, where the techniques disclosed herein are useful to estimate the relevant parameters without requiring any source parameters, inverter settings, or other source-related information.

Various effects and advantages are attained by the data processing system and method according to embodiments. The data processing systems and methods provide enhanced techniques of locating a fault along a line for the most common types of faults (namely phase-ground faults and/or phase-phase-ground faults). The data processing systems and methods facilitate fault location determination even in power grids that use environmentally friendly renewable energy resources, at least for phase-ground faults and/or phase-phase-ground faults. The data processing systems and methods are operative to determine the fault location even when inverter-based resources are connected to one or both ends of the line via buses and/or even when no measurements obtained at a remote end of the line are available, at least for phase-ground faults and/or phase-phase-ground faults. The data processing systems and methods can determine a fault location, at least for phase-ground faults and/or phase-phase-ground faults, when inverter-based resources (IBRs) are coupled to one or both ends of the line. The data processing systems and methods are operative to determine the fault location, at least for phase-ground faults and/or phase-phase-ground faults, both when used in association with a line that has an IBR coupled to one or both of its ends and when used in association with a line that has non-IBR power sources coupled to both of its ends.

While embodiments have been described with reference to the drawings, modifications and alterations may be implemented in other embodiments.

For illustration, while PV and inverter-based wind power plants have been disclosed in association with some embodiments, the data processing systems and method can also be used in association with other IBRs.

While embodiments have been described in which the line is a high voltage transmission line or an extra high voltage transmission line, the embodiments are not limited thereto.

Embodiments may be used in association with electric power systems that may but do not need to comprise IBRs. As explained in detail herein, the techniques disclosed herein remain operative even for conventional electric power systems having conventional sources on both ends of a transmission line.

This description and the accompanying drawings that illustrate aspects and embodiments of the present invention should not be taken as limiting-the claims defining the protected invention. In other words, while the invention has been illustrated and described in detail in the drawings and foregoing description, such illustration and description are to be considered illustrative and not restrictive. Various mechanical, compositional, structural, electrical, and operational changes may be made without departing from the scope of the claims. In some instances, well-known circuits, structures and techniques have not been shown in detail in order not to obscure the invention. Thus, it will be understood that changes and modifications may be made by those of ordinary skill within the scope of the following claims. In particular, the present invention covers further embodiments with any combination of features from different embodiments described above and below.

The disclosure also covers all further features shown in the Figures individually although they may not have been described in the afore or following description. Also, single alternatives of the embodiments described in the Figures and the description and single alternatives of features thereof can be disclaimed from the subject matter of the invention or from disclosed subject matter. The disclosure comprises subject matter consisting of the features defined in the claims or the embodiments as well as subject matter comprising said features.

The term "comprising" does not exclude other elements or process blocks, and the indefinite article "a" or "an" does not exclude a plurality. A single unit or process block may fulfil the functions of several features recited in the claims. The mere fact that certain measures are recited in mutually different dependent claims does not indicate that a combination of these measures cannot be used to advantage. Components described as coupled or connected may be electrically or mechanically directly coupled, or they may be indirectly coupled via one or more intermediate components. Any reference signs in the claims should not be construed as limiting the scope.

A machine-readable instruction code may be stored/distributed on a suitable medium, such as an optical storage medium or a solid-state medium supplied together with or as part of other hardware, but may also be distributed in other forms, such as via a wide area network or other wired or wireless telecommunication systems. Furthermore, a machine-readable instruction code can also be a data structure product or a signal for embodying a specific method such as the method according to embodiments.

## Claims

1. A data processing system (20) operative to determine a fault location along a line (11) based on measurements performed at an end of the line, the data processing system (20) comprising:
at least one interface (21) operative to receive the measurements; and
at least one processing circuit (24) operative to
process the received measurements to determine a zero sequence fault current, and
perform a fault location determination based on the zero sequence fault current;
wherein the zero sequence fault current has a zero sequence fault current phase angle, and
wherein the fault location determination is performed based on the zero sequence fault current phase angle;
wherein the fault location determination comprises a determination of a line current phase angle in a faulted state based on the zero sequence fault current;
wherein the data processing system (20) is operative to determine the line current phase angle for a phase-phase-ground fault as being equal to a phase angle of a sum of
the zero sequence fault current multiplied by a multiplicative factor,
a current of a first faulted phase, and
a current of a second faulted phase.

2. The data processing system of claim 1, wherein the fault location determination comprises a determination of a fault current phase angle based on the zero sequence fault current phase angle.

3. The data processing system of claim 2, wherein the data processing system is operative to determine the line current phase angle in the faulted state based on both a magnitude of the zero sequence fault current and based on the zero sequence fault current phase angle.

4. The data processing system of any one of the preceding claims, wherein the data processing system is operative to determine the line current phase angle in the faulted state based on the zero sequence fault current and at least one current measurement for a faulted phase.

5. The data processing system of any one of the preceding claims, wherein the data processing system is operative to determine the line current phase angle for a phase-ground fault as being equal to a phase angle of a sum of
the zero sequence fault current multiplied by the multiplicative factor and
a current of the faulted phase.

6. The data processing system of any one of the preceding claims
wherein the multiplicative factor is a function of line parameters of the line, or wherein the multiplicative factor is a function of a zero sequence line impedance and a positive sequence line impedance of the line.

7. The data processing system of any one of the preceding claims, wherein the data processing system is operative to determine a fault type and perform the fault location determination using processing operations that depend on the determined fault type.

8. The data processing system of any one of the preceding claims, wherein the data processing system is operative to perform different processing operations for determining the line current phase angle in the faulted state depending on whether the fault is a phase-ground fault or the phase-phase-ground fault.

9. The data processing system of claim 5 when dependent on claim 2 or of claim 8 when dependent on claim 2, wherein the data processing system is operative to perform identical processing operations for determining the fault current phase angle independently of whether the fault is a phase-ground fault or the phase-phase-ground fault.

10. The data processing system of any one of the preceding claims, wherein the data processing system is operative to determine the zero sequence fault current phase angle independently of any measurements obtained at a remote end of the line, and/or
wherein the fault location determination is a single-ended fault location determination that uses the measurements obtained at a single end of the line and that is independent of any measurements obtained at a remote end of the line.

11. The data processing system of any one of the preceding claims, wherein the data processing system is operative to determine the zero sequence fault current phase angle independently of source parameters of one or several source(s) connected to the line via a bus, and/or wherein the data processing system is operative to perform the fault location determination independently of source parameters of one or several source(s) connected to the line via a bus.

12. The data processing system of any one of the preceding claims,
wherein the fault location determination is operative to determine the fault location for grounded faults, optionally wherein the data processing system is operative to perform a fallback fault location routine if the fault is a non-grounded fault, and/or
wherein the output comprises one or both of:
an output via a human machine interface indicating the determined fault location;
a trigger for execution of at least one control function, in particular at least one protection function, based on the determined fault location.

13. A system (10), comprising:
a line (11) having a first end and a second end;
measurement instrumentation (14, 15) operative to measure voltages and currents at the first end of the line; and
the data processing system (20) of any one of the preceding claims, wherein the at least one interface (21) is operative to receive the measurements from the measurement instrumentation (14, 15), and wherein the data processing system (20) is operative to determine a fault location along the line (11),
optionally further comprising one or several inverted based resources, IBRs (12, 13), connected to the first end or the second end.

14. A method of determining a fault location along a line based on measurements performed at an end of the line, the data processing method comprising:
processing, by at least one processing circuit (24), the measurements to determine a zero sequence fault current; and
performing, by the at least one processing circuit (24), a fault location determination based on the zero sequence fault current;
wherein the zero sequence fault current has a zero sequence fault current phase angle;
wherein the fault location determination is performed based on the zero sequence fault current phase angle;
wherein the fault location determination comprises a determination of a line current phase angle in a faulted state based on the zero sequence fault current;
wherein the at least one processing circuit (24) determines the line current phase angle for a phase-phase-ground fault as being equal to a phase angle of a sum of
the zero sequence fault current multiplied by a multiplicative factor,
a current of a first faulted phase, and
a current of a second faulted phase.

15. Machine-readable instruction code which, when executed by at least one programmable circuit (24), causes the at least one programmable circuit (24) to perform the method according to claim 14.

## Patentansprüche

1. Datenverarbeitungssystem (20), das eingerichtet ist zum Bestimmen eines Fehlerorts entlang einer Leitung (11) auf Basis von an einem Ende der Leitung durchgeführten Messungen, wobei das Datenverarbeitungssystem (20) aufweist:
mindestens eine Schnittstelle (21), die eingerichtet ist zum Empfangen der Messungen; und
mindestens eine Verarbeitungsschaltung (24), die eingerichtet ist zum
Verarbeiten der empfangenen Messungen, um einen Nullsystem-Fehlerstrom zu bestimmen, und
Durchführen einer Fehlerortbestimmung auf Basis des Nullsystem-Fehlerstroms,
wobei der Nullsystem-Fehlerstrom einen Phasenwinkel des Nullsystem-Fehlerstroms aufweist; wobei die Fehlerortbestimmung auf Basis des Phasenwinkels des Nullsystem-Fehlerstroms durchgeführt wird;
wobei die Fehlerortbestimmung ein Bestimmen eines Leitungsstrom-Phasenwinkels in einem Fehlerzustand auf Basis des Nullsystem-Fehlerstroms umfasst;
wobei das Datenverarbeitungssystem (20) eingerichtet ist, den Leitungsstrom-Phasenwinkel für einen Phasen-Phasen-Erdschluss als gleich einem Phasenwinkel einer Summe aus
dem mit einem Multiplikationsfaktor multiplizierten Nullsystem-Fehlerstrom,
einem Strom einer ersten fehlerbehafteten Phase und
einem Strom einer zweiten fehlerbehafteten Phase
zu bestimmen.

2. Datenverarbeitungssystem nach Anspruch 1, wobei die Fehlerortbestimmung ein Bestimmen eines Fehlerstrom-Phasenwinkels auf Basis des Phasenwinkels des Nullsystem-Fehlerstroms umfasst.

3. Datenverarbeitungssystem nach Anspruch 2, wobei das Datenverarbeitungssystem eingerichtet ist, den Leitungsstrom-Phasenwinkel in dem Fehlerzustand auf Basis sowohl eines Betrags des Nullsystem-Fehlerstroms als auch auf Basis des Phasenwinkels des Nullsystem-Fehlerstroms zu bestimmen.

4. Datenverarbeitungssystem nach einem der vorhergehenden Ansprüche, wobei das Datenverarbeitungssystem eingerichtet ist, den Leitungsstrom-Phasenwinkel in dem Fehlerzustand auf Basis des Nullsystem-Fehlerstroms und mindestens einer Strommessung für eine fehlerbehaftete Phase zu bestimmen.

5. Datenverarbeitungssystem nach einem der vorhergehenden Ansprüche, wobei das Datenverarbeitungssystem eingerichtet ist, den Leitungsstrom-Phasenwinkel für einen Phasen-Erdschluss als gleich einem Phasenwinkel einer Summe aus
dem mit dem Multiplikationsfaktor multiplizierten Nullsystem-Fehlerstrom und
einem Strom der fehlerbehafteten Phase
zu bestimmen.

6. Datenverarbeitungssystem nach einem der vorhergehenden Ansprüche,
wobei der Multiplikationsfaktor eine Funktion von Leitungsparametern der Leitung ist, oder wobei der Multiplikationsfaktor eine Funktion einer Nullsystem-Leitungsimpedanz und einer Mitsystem-Leitungsimpedanz der Leitung ist.

7. Datenverarbeitungssystem nach einem der vorhergehenden Ansprüche,
wobei das Datenverarbeitungssystem eingerichtet ist, einen Fehlertyp zu bestimmen und die Fehlerortbestimmung unter Verwendung von Verarbeitungsoperationen durchzuführen, die von dem bestimmten Fehlertyp abhängen.

8. Datenverarbeitungssystem nach einem der vorhergehenden Ansprüche, wobei das Datenverarbeitungssystem eingerichtet ist, abhängig davon, ob der Fehler ein Phasen-Erdschluss oder der Phasen-Phasen-Erdschluss ist, unterschiedliche Verarbeitungsoperationen zum Bestimmen des Leitungsstrom-Phasenwinkels in dem Fehlerzustand durchzuführen.

9. Datenverarbeitungssystem nach Anspruch 5 in Abhängigkeit von Anspruch 2 oder nach Anspruch 8 in Abhängigkeit von Anspruch 2, wobei das Datenverarbeitungssystem eingerichtet ist, unabhängig davon, ob der Fehler ein Phasen-Erdschluss oder der Phasen-Phasen-Erdschluss ist, identische Verarbeitungsoperationen zum Bestimmen des Fehlerstrom-Phasenwinkels durchzuführen.

10. Datenverarbeitungssystem nach einem der vorhergehenden Ansprüche, wobei das Datenverarbeitungssystem eingerichtet ist, den Phasenwinkel des Nullsystem-Fehlerstroms unabhängig von jeglichen an einem fernen Ende der Leitung erhaltenen Messungen zu bestimmen, und/oder
wobei die Fehlerortbestimmung eine einseitige Fehlerortbestimmung ist, die die an nur einem Ende der Leitung erhaltenen Messungen verwendet und die unabhängig von jeglichen an einem fernen Ende der Leitung erhaltenen Messungen ist.

11. Datenverarbeitungssystem nach einem der vorhergehenden Ansprüche, wobei das Datenverarbeitungssystem eingerichtet ist, den Phasenwinkel des Nullsystem-Fehlerstroms unabhängig von Quellenparametern einer oder mehrerer über eine Sammelschiene mit der Leitung verbundener Quelle(n) zu bestimmen, und/oder
wobei das Datenverarbeitungssystem eingerichtet ist, die Fehlerortbestimmung unabhängig von Quellenparametern einer oder mehrerer über eine Sammelschiene mit der Leitung verbundener Quelle(n) durchzuführen.

12. Datenverarbeitungssystem nach einem der vorhergehenden Ansprüche,
wobei die Fehlerortbestimmung eingerichtet ist, den Fehlerort für Erdschlüsse zu bestimmen, optional wobei das Datenverarbeitungssystem eingerichtet ist, eine Ersatz-Fehlerortbestimmungsroutine durchzuführen, wenn der Fehler kein Erdschluss ist, und/oder wobei die Ausgabe eines oder beide der folgenden umfasst:
eine Ausgabe über eine Mensch-Maschine-Schnittstelle, die den bestimmten Fehlerort angibt;
einen Auslöser zum Ausführen mindestens einer Steuerungsfunktion, insbesondere mindestens einer Schutzfunktion, auf Basis des bestimmten Fehlerorts.

13. System (10), aufweisend:
eine Leitung (11) mit einem ersten Ende und einem zweiten Ende;
Messeinrichtungen (14, 15), die eingerichtet sind zum Messen von Spannungen und Strömen an dem ersten Ende der Leitung; und
das Datenverarbeitungssystem (20) nach einem der vorhergehenden Ansprüche, wobei die mindestens eine Schnittstelle (21) eingerichtet ist, die Messungen von den Messeinrichtungen (14, 15) zu empfangen, und wobei das Datenverarbeitungssystem (20) eingerichtet ist, einen Fehlerort entlang der Leitung (11) zu bestimmen,
optional ferner aufweisend eine oder mehrere inverterbasierte Ressource(n), IBRs (12, 13), die mit dem ersten Ende oder dem zweiten Ende verbunden ist oder sind.

14. Verfahren zum Bestimmen eines Fehlerorts entlang einer Leitung auf Basis von an einem Ende der Leitung durchgeführten Messungen, wobei das Datenverarbeitungsverfahren umfasst:
Verarbeiten der Messungen durch mindestens eine Verarbeitungsschaltung (24), um einen Nullsystem-Fehlerstrom zu bestimmen; und
Durchführen einer Fehlerortbestimmung durch die mindestens eine Verarbeitungsschaltung (24) auf Basis des Nullsystem-Fehlerstroms;
wobei der Nullsystem-Fehlerstrom einen Phasenwinkel des Nullsystem-Fehlerstroms aufweist;
wobei die Fehlerortbestimmung auf Basis des Phasenwinkels des Nullsystem-Fehlerstroms durchgeführt wird;
wobei die Fehlerortbestimmung ein Bestimmen eines Leitungsstrom-Phasenwinkels in einem Fehlerzustand auf Basis des Nullsystem-Fehlerstroms umfasst;
wobei die mindestens eine Verarbeitungsschaltung (24) den Leitungsstrom-Phasenwinkel für einen Phasen-Phasen-Erdschluss als gleich einem Phasenwinkel einer Summe aus
dem mit einem Multiplikationsfaktor multiplizierten Nullsystem-Fehlerstrom,
einem Strom einer ersten fehlerbehafteten Phase und
einem Strom einer zweiten fehlerbehafteten Phase
bestimmt.

15. Maschinenlesbarer Instruktionscode, der bei Ausführung durch mindestens eine programmierbare Schaltung (24) die mindestens eine programmierbare Schaltung (24) zur Durchführung des Verfahrens nach Anspruch 14 veranlasst.

## Revendications

1. Système de traitement de données (20) adapté pour déterminer un emplacement de défaut le long d'une ligne (11) sur la base de mesures effectuées au niveau d'une extrémité de la ligne, le système de traitement de données (20) comprenant :
au moins une interface (21) adaptée pour recevoir les mesures ; et
au moins un circuit de traitement (24) adapté pour
traiter les mesures reçues pour déterminer un courant de défaut de séquence nulle, et
effectuer une détermination d'emplacement de défaut sur la base du courant de défaut de séquence nulle ; dans lequel le courant de défaut de séquence nulle présente un angle de phase de courant de défaut de séquence nulle, et
dans lequel la détermination d'emplacement de défaut est effectuée sur la base de l'angle de phase de courant de défaut de séquence nulle ;
dans lequel la détermination d'emplacement de défaut comprend une détermination d'un angle de phase de courant de ligne en état défectueux sur la base du courant de défaut de séquence nulle ;
dans lequel le système de traitement de données (20) est adapté pour déterminer l'angle de phase de courant de ligne pour un défaut de type phase-phase-terre comme étant égal à un angle de phase d'une somme
du courant de défaut de séquence nulle multiplié par un facteur multiplicatif,
d'un courant d'une première phase défectueuse, et
d'un courant d'une deuxième phase défectueuse.

2. Système de traitement de données selon la revendication 1, dans lequel la détermination d'emplacement de défaut comprend une détermination d'un angle de phase de courant de défaut sur la base de l'angle de phase de courant de défaut de séquence nulle.

3. Système de traitement de données selon la revendication 2, dans lequel le système de traitement de données est adapté pour déterminer l'angle de phase de courant de ligne en état défectueux à la fois sur la base d'une amplitude du courant de défaut de séquence nulle et sur la base de l'angle de phase de courant de défaut de séquence nulle.

4. Système de traitement de données selon l'une quelconque des revendications précédentes, dans lequel le système de traitement de données est adapté pour déterminer l'angle de phase de courant de ligne en état défectueux sur la base du courant de défaut de séquence nulle et d'au moins une mesure de courant pour une phase défectueuse.

5. Système de traitement de données selon l'une quelconque des revendications précédentes, dans lequel le système de traitement de données est adapté pour déterminer l'angle de phase de courant de ligne pour un défaut de type phase-terre comme étant égal à un angle de phase d'une somme
du courant de défaut de séquence nulle multiplié par le facteur multiplicatif, et
d'un courant de la phase défectueuse.

6. Système de traitement de données selon l'une quelconque des revendications précédentes,
dans lequel le facteur multiplicatif est une fonction de paramètres de ligne de la ligne, ou dans lequel le facteur multiplicatif est une fonction d'une impédance de ligne de séquence nulle et d'une impédance de ligne de séquence positive de la ligne.

7. Système de traitement de données selon l'une quelconque des revendications précédentes, dans lequel le système de traitement de données est adapté pour déterminer un type de défaut et effectuer la détermination d'emplacement de défaut à l'aide d'opérations de traitement qui dépendent du type de défaut déterminé.

8. Système de traitement de données selon l'une quelconque des revendications précédentes, dans lequel le système de traitement de données est adapté pour effectuer des opérations de traitement différentes pour déterminer l'angle de phase de courant de ligne en état défectueux selon que le défaut est un défaut de type phase-terre ou un défaut de type phase-phase-terre.

9. Système de traitement de données selon la revendication 5 lorsqu'elle dépend de la revendication 2 ou selon la revendication 8 lorsqu'elle dépend de la revendication 2, dans lequel le système de traitement de données est adapté pour effectuer des opérations de traitement identiques pour déterminer l'angle de phase de courant de défaut indépendamment du fait que le défaut soit un défaut de type phase-terre ou un défaut de type phase-phase-terre.

10. Système de traitement de données selon l'une quelconque des revendications précédentes, dans lequel le système de traitement de données est adapté pour déterminer l'angle de phase de courant de défaut de séquence nulle indépendamment de toutes mesures obtenues au niveau d'une extrémité distante de la ligne, et/ou
dans lequel la détermination d'emplacement de défaut est une détermination d'emplacement de défaut basée sur une seule extrémité qui utilise les mesures obtenues au niveau d'une extrémité unique de la ligne et qui est indépendante de toutes mesures obtenues au niveau d'une extrémité distante de la ligne.

11. Système de traitement de données selon l'une quelconque des revendications précédentes, dans lequel le système de traitement de données est adapté pour déterminer l'angle de phase de courant de défaut de séquence nulle indépendamment de paramètres de source d'une ou plusieurs source(s) connectée(s) à la ligne via un bus, et/ou
dans lequel le système de traitement de données est adapté pour effectuer la détermination d'emplacement de défaut indépendamment de paramètres de source d'une ou plusieurs source(s) connectée(s) à la ligne via un bus.

12. Système de traitement de données selon l'une quelconque des revendications précédentes,
dans lequel la détermination d'emplacement de défaut est adaptée pour déterminer l'emplacement de défaut pour des défauts avec mise à la terre, optionnellement dans lequel le système de traitement de données est adapté pour effectuer une routine de localisation de défaut de secours si le défaut est un défaut sans mise à la terre, et/ou
dans lequel la sortie comprend l'un et/ou l'autre parmi :
une sortie via une interface homme-machine indiquant l'emplacement de défaut déterminé ;
un déclencheur pour l'exécution d'au moins une fonction de commande, en particulier au moins une fonction de protection, sur la base de l'emplacement de défaut déterminé.

13. Système (10), comprenant :
une ligne (11) présentant une première extrémité et une deuxième extrémité ;
une instrumentation de mesure (14, 15) adaptée pour mesurer des tensions et des courants au niveau de la première extrémité de la ligne ; et
le système de traitement de données (20) selon l'une quelconque des revendications précédentes, dans lequel l'au moins une interface (21) est adaptée pour recevoir les mesures provenant de l'instrumentation de mesure (14, 15), et dans lequel le système de traitement de données (20) est adapté pour déterminer un emplacement de défaut le long de la ligne (11),
optionnellement, comprenant en outre une ou plusieurs ressource(s) à base d'onduleur, IBR, (12, 13), connectées à la première extrémité ou à la deuxième extrémité.

14. Procédé de détermination d'un emplacement de défaut le long d'une ligne sur la base de mesures effectuées au niveau d'une extrémité de la ligne, le procédé de traitement de données comprenant :
le traitement, par au moins un circuit de traitement (24), des mesures pour déterminer un courant de défaut de séquence nulle ; et
la réalisation, par l'au moins un circuit de traitement (24), d'une détermination d'emplacement de défaut sur la base du courant de défaut de séquence nulle ;
dans lequel le courant de défaut de séquence nulle présente un angle de phase de courant de défaut de séquence nulle ;
dans lequel la détermination d'emplacement de défaut est effectuée sur la base de l'angle de phase de courant de défaut de séquence nulle ;
dans lequel la détermination d'emplacement de défaut comprend une détermination d'un angle de phase de courant de ligne en état défectueux sur la base du courant de défaut de séquence nulle ;
dans lequel l'au moins un circuit de traitement (24) détermine l'angle de phase de courant de ligne pour un défaut de type phase-phase-terre comme étant égal à un angle de phase d'une somme
du courant de défaut de séquence nulle multiplié par un facteur multiplicatif,
d'un courant d'une première phase défectueuse, et
d'un courant d'une deuxième phase défectueuse.

15. Code d'instructions lisible par machine qui, lorsqu'il est exécuté par au moins un circuit programmable (24), amène l'au moins un circuit programmable (24) à réaliser le procédé selon la revendication 14.
